# FASCICULE DE BREVET EUROPEEN

(11) **EP 4 202 175 B1**
(45) Date de publication et mention de la délivrance du brevet: **16.09.2026**
(21) Numéro de dépôt: 22215818.0
(22) Date de dépôt: 22.12.2022
(51) Int. Cl.: E06B 9/68, E06B 9/72, H02J 7/00, H02J 7/80, H02J 7/90, H02J 7/96, G01R 31/36, E06B 9/24, H02J 7/35

(54) **PROCÉDÉ DE COMMANDE EN FONCTIONNEMENT D'UN DISPOSITIF D'ENTRAÎNEMENT MOTORISÉ, DISPOSITIF D'ENTRAÎNEMENT MOTORISÉ ET DISPOSITIF D'OCCULTATION ASSOCIÉS**
VERFAHREN ZUR BETRIEBSSTEUERUNG EINER MOTORISCHEN ANTRIEBSVORRICHTUNG, MOTORISIERTE ANTRIEBSVORRICHTUNG UND VERDUNKELUNGSVORRICHTUNG DAFÜR
METHOD FOR CONTROLLING THE OPERATION OF A MOTORISED DRIVE DEVICE, ASSOCIATED MOTORISED DRIVE DEVICE AND SCREEN DEVICE

(30) Priorité: 23.12.2021 FR 2114349
(43) Date de publication de la demande: 28.06.2023
(73) Titulaire: Somfy Activites SA, 74300 Cluses (FR)
(72) Inventeur: BOSSE, Ben, 74300 CLUSES (FR); FAURE, David, 74300 CLUSES (FR); TINE, Damien, 74300 CLUSES (FR); ROUSSEAU, Fabien, 74300 CLUSES (FR); BRUNO, Serge, 74300 CLUSES (FR)
(74) Mandataire: Lavoix

(56) Documents cités:
- FR-A1- 2 907 612
- US-B1- 7 218 118
- LARRY W JUANG ET AL: "Implementation of online battery state-of-power and state-of-function estimation in electric vehicle applications", ENERGY CONVERSION CONGRESS AND EXPOSITION (ECCE), 2012 IEEE, IEEE, 15 September 2012 (2012-09-15), pages 1819 - 1826, XP032467406, ISBN: 978-1-4673-0802-1, DOI: 10.1109/ECCE.2012.6342591

## Description

La présente invention concerne un procédé de commande en fonctionnement d'un dispositif d'entraînement motorisé.

En outre, la présente invention concerne un dispositif d'entraînement motorisé, en particulier pour un dispositif d'occultation, autrement dit un dispositif d'entraînement motorisé d'un dispositif d'occultation, configuré pour mettre en oeuvre un tel procédé de commande, autrement dit mettant en oeuvre un tel procédé de commande, ainsi qu'un dispositif d'occultation comprenant un tel dispositif d'entraînement motorisé.

De manière générale, la présente invention concerne le domaine des dispositifs d'occultation comprenant un dispositif d'entraînement motorisé mettant en mouvement un écran, entre au moins une première position et au moins une deuxième position.

Un dispositif d'entraînement motorisé comprend un actionneur électromécanique d'un élément mobile de fermeture, d'occultation ou de protection solaire, tel qu'un volet, une porte, une grille, un store ou tout autre matériel équivalent, appelé par la suite écran.

On connaît déjà un dispositif d'entraînement motorisé d'un dispositif d'occultation. Le dispositif d'entraînement motorisé comprend un actionneur électromécanique, une unité électronique de contrôle et un dispositif d'alimentation en énergie électrique. L'actionneur électromécanique comprend un moteur électrique. Le dispositif d'alimentation en énergie électrique comprend une batterie. L'unité électronique de contrôle et le moteur électrique sont alimentés en énergie électrique à partir de la batterie. La batterie délivre une tension.

Il est connu d'observer un niveau de charge de la batterie, exprimé en pourcentage de la charge maximale de la batterie, afin d'estimer l'autonomie disponible du dispositif d'entraînement motorisé. Ce niveau de charge de la batterie est généralement affiché, ce qui permet à un utilisateur du dispositif d'entraînement motorisé de connaître l'estimation de cette autonomie restante. Ainsi, lorsque l'autonomie affichée est faible, l'utilisateur sait qu'il est nécessaire de procéder à une recharge de la batterie.

Cependant, ce dispositif d'entraînement motorisé présente l'inconvénient que le niveau de charge de la batterie n'est pas suffisant pour estimer avec précision l'autonomie du dispositif d'entraînement motorisé.

En effet, cette autonomie dépend de nombreux autres paramètres, tels que par exemple l'âge de la batterie, la température de la batterie et/ou le régime de décharge de la batterie, autrement dit la valeur de courants de décharge de la batterie pour alimenter en énergie électrique l'actionneur électromécanique, qui ne sont pas pris en compte pour estimer l'autonomie disponible mais qui ont une grande influence sur l'autonomie réelle du dispositif d'entraînement motorisé.

Par ailleurs, la prise en compte de l'âge de la batterie et de sa température seraient complexes, car les conséquences du vieillissement d'une batterie ou de l'évolution de sa température sur sa capacité sont difficiles à maîtriser.

Avec un tel dispositif d'entraînement motorisé, il est ainsi possible d'afficher un niveau de charge maximal, alors que la batterie est en fin de vie et dans de mauvaises conditions de température, conduisant l'autonomie réelle à être très faible.

On connaît également le document FR 2 907 612 A1 décrit un procédé de commande en fonctionnement d'un dispositif d'entraînement motorisé d'un dispositif d'occultation. Le dispositif d'entraînement motorisé comprend un actionneur électromécanique, une unité électronique de contrôle et un dispositif d'alimentation en énergie électrique. L'actionneur électromécanique comprend un moteur électrique. Le dispositif d'alimentation en énergie électrique comprend une batterie. L'unité électronique de contrôle et le moteur électrique sont alimentés en énergie électrique à partir de la batterie. La batterie délivre une tension. La détermination de l'énergie disponible dans la batterie est mise en œuvre par une mesure de la tension délivrée par la batterie lorsqu'un écran mobile est dans une position donnée, en particulier déployée, qui est déterminée en parallèle, au cours d'une même étape du procédé. La détermination de l'énergie disponible dans la batterie est mise en œuvre suite à la réception d'un ordre de commande de déplacement de l'écran et avant l'exécution de ce déplacement au moyen de l'actionneur puis un signalement est mis en œuvre à destination de l'utilisateur concernant un nombre d'ordres de commande, identiques à celui qui vient d'être exécuté, qui peuvent encore être exécutés.

On connaît également le document US 7 218 118 B1 décrit un procédé de commande en fonctionnement d'un starter pour un moteur à combustion interne, qui est alimenté par une batterie. Le procédé comprend une phase de mesure, mise en œuvre pendant une période de fonctionnement du starter. Au cours de laquelle, le procédé comprend une étape de mesure en fonctionnement de la tension délivrée par la batterie et une étape d'enregistrement en fonctionnement d'une valeur minimale de la tension délivrée par la batterie. Le procédé comprend une phase d'analyse. Au cours de laquelle, le procédé comprend une étape d'établissement, sur la base de la valeur minimale de la tension enregistrée au cours de la phase de mesure, d'un indicateur représentatif de l'autonomie de la batterie, consistant à émettre des messages informatifs à l'utilisateur pour vérifier l'état de la batterie, voire de la remplacer.

On connaît également l'article IEEE de Larry W JUANG et AL (« Implementation of online battery State-of-Power and State-of-Function estimation in electric vehicles applications ») divulgue un procédé d'estimation d'un état de fonctionnement d'une batterie pour un véhicule électrique par une mesure de la tension délivrée par la batterie. L'état de fonctionnement est un paramètre binaire statuant si la batterie a une quantité d'énergie suffisante pour mettre en oeuvre une fonction, telle que le démarrage d'un moteur.

La présente invention a pour but de résoudre les inconvénients précités et de proposer un procédé de commande en fonctionnement d'un dispositif d'entraînement motorisé, un dispositif d'entraînement motorisé configuré pour mettre en oeuvre un tel procédé de commande, ainsi qu'un dispositif d'occultation comprenant un tel dispositif d'entraînement motorisé, permettant d'estimer avec précision l'autonomie d'une batterie, sans se baser nécessairement sur le niveau de charge de la batterie et sans devoir connaître explicitement l'état de la batterie.

À cet égard, la présente invention vise, selon un premier aspect, un procédé de commande en fonctionnement d'un dispositif d'entraînement motorisé,
le dispositif d'entraînement motorisé comprenant au moins :
   - un actionneur électromécanique,
   - une unité électronique de contrôle, et
   - un dispositif d'alimentation en énergie électrique,
l'actionneur électromécanique comprenant au moins un moteur électrique,
le dispositif d'alimentation en énergie électrique comprenant au moins une batterie, l'unité électronique de contrôle et le moteur électrique étant alimentés en énergie électrique à partir de la batterie, la batterie délivrant une tension.

Selon l'invention, le procédé comprend au moins :
- une phase de mesure, mise en oeuvre pendant une période de fonctionnement du moteur électrique, au cours de laquelle, le procédé comprend au moins :
   - une étape de mesure en fonctionnement de la tension délivrée par la batterie, et
   - une étape d'enregistrement en fonctionnement d'une valeur minimale de la tension délivrée par la batterie,
- et une phase d'analyse, au cours de laquelle, le procédé comprend au moins :
   - une étape d'établissement, sur la base de la valeur minimale de la tension enregistrée au cours de la phase de mesure, d'un indicateur représentatif de l'autonomie de la batterie, et
   - après la période de fonctionnement du moteur électrique, si l'indicateur est égal à un état d'indication critique, une routine interdisant le fonctionnement du moteur électrique, la routine étant exécutée tant que l'indicateur est égal à l'état d'indication critique.

En outre, le procédé est mis en oeuvre lorsque le dispositif d'entraînement motorisé entraîne en déplacement un écran d'un dispositif d'occultation, dans un mouvement de l'écran requérant la plus grande puissance délivrée par l'actionneur électromécanique.

Ainsi, l'indicateur représentatif de l'autonomie de la batterie est établi sur la base de la valeur minimale de la tension délivrée par la batterie, au cours de la période de fonctionnement du moteur électrique.

De cette manière, l'indicateur est basé sur les performances réelles de la batterie et du moteur électrique. Ceci conduit à établir un indicateur fiable et particulièrement adapté pour rendre compte de l'autonomie réelle du dispositif d'entraînement motorisé.

Cette autonomie peut ainsi être exprimée en un nombre de cycles de fonctionnement de l'actionneur électromécanique, plutôt qu'en pourcentage de charge de la batterie.

Par conséquent, un utilisateur du dispositif d'entraînement motorisé dispose d'une estimation fiable et concrète de l'autonomie de la batterie, qui en outre ne nécessite pas de déterminer explicitement l'état et la charge de la batterie.

Selon une caractéristique avantageuse de l'invention, le mouvement de l'écran requérant la plus grande puissance délivrée par l'actionneur électromécanique est un mouvement de montée de l'écran.

Selon une autre caractéristique avantageuse de l'invention, le procédé comprend, en outre, une phase d'initialisation, mise en oeuvre préalablement à la période de fonctionnement du moteur électrique, au cours de laquelle, le procédé comprend, en outre :
- une étape de mesure préalable de la tension délivrée par la batterie, et
- une étape d'enregistrement préalable d'une valeur de la tension mesurée comme étant une valeur de référence.

Le procédé comprend, en outre, au cours de la routine interdisant le fonctionnement du moteur électrique et tant que l'indicateur est égal à l'état d'indication critique :
- une étape de mesure ultérieure de la tension délivrée par la batterie, et
- une étape de comparaison ultérieure d'une valeur de la tension mesurée à la valeur de référence.

Si la valeur de la tension mesurée, lors de l'étape de mesure ultérieure, est strictement inférieure à une somme de la valeur de référence de la tension et d'un premier facteur de correction prédéterminé, le procédé met en oeuvre, au cours de la routine, de nouveau les étapes de mesure ultérieure et de comparaison ultérieure, après une étape de temporisation.

Si la valeur de la tension mesurée, lors de l'étape de mesure ultérieure, est supérieure ou égale à la somme de la valeur de référence de la tension et du premier facteur de correction prédéterminé, le procédé comprend, en outre, au cours de la routine :
- une étape de modification de l'indicateur, de sorte à ce que l'indicateur soit différent de l'état d'indication critique, et
- une étape de fin de la routine.

En outre, le premier facteur de correction prédéterminé est une valeur de tension prédéterminée supérieure ou égale à zéro.

Selon une autre caractéristique avantageuse de l'invention, le dispositif d'alimentation en énergie électrique comprend, en outre, un panneau photovoltaïque, le panneau photovoltaïque alimentant en énergie électrique la batterie.

En outre, le procédé comprend, en outre :
- au cours de la phase d'initialisation, une étape de modification préalable de la valeur de référence de la tension d'un deuxième facteur de correction, le deuxième facteur de correction étant fonction de l'intensité du courant électrique mesurée au niveau du panneau photovoltaïque, au moment de l'étape de mesure préalable de la tension délivrée par la batterie au cours de la phase d'initialisation, et
- au cours de la routine, si l'indicateur est égal à l'état d'indication critique, une étape de modification ultérieure, exécutée entre l'étape de mesure ultérieure et l'étape de comparaison ultérieure de la routine, de la valeur de la tension mesurée avec un troisième facteur de correction, le troisième facteur de correction étant fonction de l'intensité du courant électrique mesurée au niveau du panneau photovoltaïque, au moment de l'étape de mesure ultérieure de la tension délivrée par la batterie au cours de la routine.

Selon une autre caractéristique avantageuse de l'invention, au cours de l'étape d'établissement de l'indicateur, l'indicateur est défini comme étant égal à l'état d'indication critique si la valeur minimale de la tension est strictement inférieure à une valeur seuil de tension prédéterminée minimale.

Selon une autre caractéristique avantageuse de l'invention, au cours de la phase de mesure, le procédé comprend, en outre :
- une étape de mesure d'une vitesse de rotation du moteur électrique, et
- une étape d'enregistrement d'une valeur maximale de la vitesse de rotation du moteur électrique.

En outre, au cours de l'étape d'établissement de l'indicateur, l'indicateur est défini comme étant égal à l'état d'indication critique, si la valeur minimale de la tension enregistrée est strictement inférieure à une valeur seuil de tension prédéterminée minimale et si la valeur maximale de la vitesse de rotation enregistrée est strictement inférieure à une valeur seuil de vitesse prédéterminée.

Selon une autre caractéristique avantageuse de l'invention, le procédé, comprend, en outre, au cours de la phase d'analyse, une étape d'affichage de l'indicateur sur un dispositif d'affichage.

La présente invention vise, selon un deuxième aspect, un dispositif d'entraînement motorisé,
le dispositif d'entraînement motorisé comprenant au moins :
- un actionneur électromécanique,
- une unité électronique de contrôle, et
- un dispositif d'alimentation en énergie électrique,
l'actionneur électromécanique comprenant au moins un moteur électrique, le dispositif d'alimentation en énergie électrique comprenant au moins une batterie, l'unité électronique de contrôle et le moteur électrique étant alimentés en énergie électrique à partir de la batterie, la batterie délivrant une tension.

Selon l'invention, l'unité électronique de contrôle du dispositif d'entraînement motorisé est configurée pour mettre en oeuvre le procédé conforme à l'invention et tel que mentionné ci-dessus.

Ce dispositif d'entraînement motorisé présente des caractéristiques et avantages analogues à ceux décrits précédemment en relation avec le procédé de commande selon l'invention et tel que mentionné ci-dessus.

La présente invention vise, selon un troisième aspect, un dispositif d'occultation comprenant au moins :
- un écran, et
- un dispositif d'entraînement motorisé.

L'écran est configuré pour être entraîné en déplacement par l'actionneur électromécanique du dispositif d'entraînement motorisé. Selon l'invention, le dispositif d'entraînement motorisé est conforme à l'invention et tel que mentionné ci-dessus.

Ce dispositif d'occultation présente des caractéristiques et avantages analogues à ceux décrits précédemment en relation avec le dispositif d'entraînement motorisé selon l'invention et tel que mentionné ci-dessus.

Selon une caractéristique avantageuse de l'invention, le dispositif d'occultation comprend, en outre, un tube d'enroulement. L'écran est enroulable sur le tube d'enroulement. En outre, le tube d'enroulement est agencé de sorte à être entraîné en rotation par l'actionneur électromécanique.

D'autres particularités et avantages de l'invention apparaîtront encore dans la description ci-après, faite en référence aux dessins annexés, donnés à titre d'exemples non limitatifs et dans lesquels :
[Fig 1] la figure 1 est une vue schématique en coupe transversale d'une installation conforme à un mode de réalisation de l'invention, l'installation comprenant un dispositif d'occultation conforme à l'invention ;
[Fig 2] la figure 2 est une vue schématique en perspective de l'installation illustrée à la figure 1 ;
[Fig 3] la figure 3 est une vue schématique en coupe axiale et partielle de l'installation illustrée aux figures 1 et 2, montrant un actionneur électromécanique d'un dispositif d'entraînement motorisé du dispositif d'occultation de l'installation ;
[Fig 4] la figure 4 est un schéma blocs d'un procédé de commande du dispositif d'entraînement motorisé du dispositif d'occultation, tel qu'illustré aux figures 1 à 3, conforme à un mode de réalisation de l'invention ; et
[Fig 5] la figure 5 regroupe trois schémas blocs, illustrant chacun un mode de réalisation d'une étape d'un algorithme illustré par le schéma blocs de la figure 4.

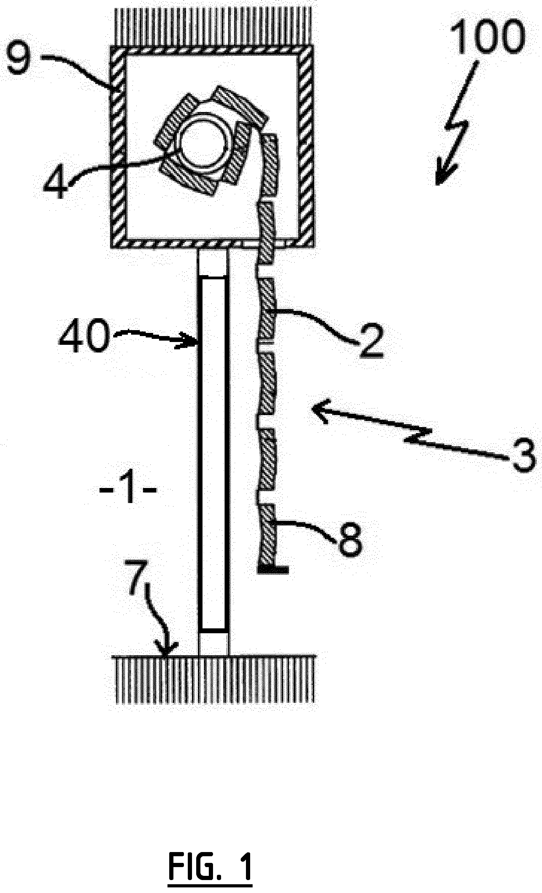

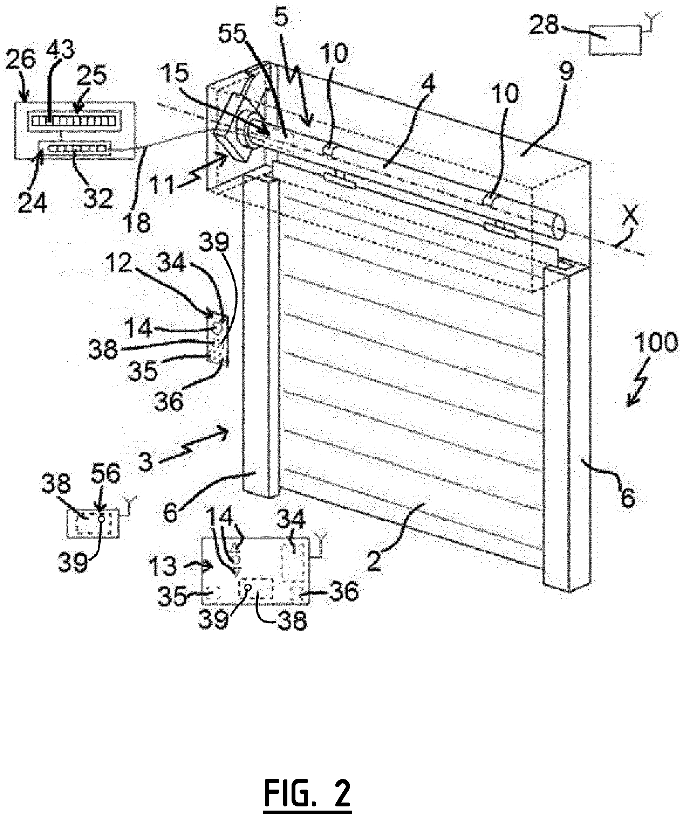

On décrit tout d'abord, en référence aux figures 1 et 2, une installation domotique 100 conforme à l'invention. Cette installation domotique 100 comprend au moins un dispositif de fermeture, d'occultation ou de protection solaire 3, conforme à un mode de réalisation l'invention. Cette installation domotique 100, installée dans un bâtiment, non représenté, comporte une ouverture 1, dans laquelle est disposée une fenêtre 40 ou une porte, qui n'est représentée qu'à la figure 1. Cette installation domotique 100 est équipée d'au moins un écran 2 appartenant au dispositif de fermeture, d'occultation ou de protection solaire 3, en particulier un volet roulant motorisé.

Le dispositif de fermeture, d'occultation ou de protection solaire 3 est par la suite appelé « dispositif d'occultation ». Le dispositif d'occultation 3 comprend l'écran 2.

Le dispositif d'occultation 3 peut être un volet roulant, un store en toile ou avec des lames orientables, un portail roulant, une grille, une porte ou encore un volet battant. La présente invention s'applique à tous les types de dispositif d'occultation.

On décrit, en référence aux figures 1 et 2, un volet roulant conforme au mode de réalisation de l'invention.

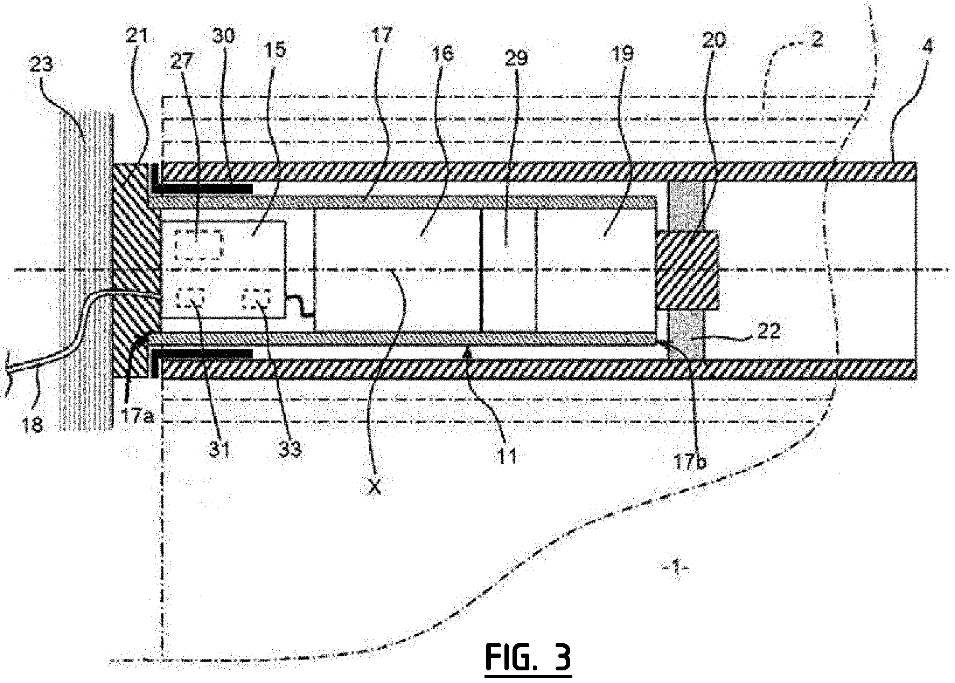

Le dispositif d'occultation 3 comprend un dispositif d'entraînement motorisé 5, conforme à l'invention. Le dispositif d'entraînement motorisé 5 comprend un actionneur électromécanique 11 illustré à la figure 3.

Avantageusement, le dispositif d'occultation 3 comprend, en outre, un tube d'enroulement 4. L'écran 2 est enroulable sur le tube d'enroulement 4. En outre, le tube d'enroulement 4 est agencé de sorte à être entraîné en rotation par l'actionneur électromécanique 11.

Ainsi, l'écran 2 du dispositif d'occultation 3 est enroulé sur le tube d'enroulement 4 ou déroulé autour de celui-ci, le tube d'enroulement 4 étant entraîné par le dispositif d'entraînement motorisé 5, en particulier par l'actionneur électromécanique 11.

De cette manière, l'écran 2 est mobile entre une position enroulée, en particulier haute, et une position déroulée, en particulier basse, et inversement.

L'écran 2 du dispositif d'occultation 3 est un écran de fermeture, d'occultation et/ou de protection solaire, s'enroulant et se déroulant autour du tube d'enroulement 4, dont le diamètre intérieur est supérieur au diamètre externe de l'actionneur électromécanique 11, de sorte que l'actionneur électromécanique 11 peut être inséré dans le tube d'enroulement 4, lors de l'assemblage du dispositif d'occultation 3.

L'actionneur électromécanique 11, en particulier de type tubulaire, permet de mettre en rotation le tube d'enroulement 4 autour d'un axe de rotation X, de sorte à déplacer, en particulier dérouler ou enrouler, l'écran 2 du dispositif d'occultation 3.

Dans un état monté du dispositif d'occultation 3, l'actionneur électromécanique 11 est inséré dans le tube d'enroulement 4.

De manière connue, le volet roulant, qui forme le dispositif d'occultation 3, comporte un tablier comprenant des lames horizontales articulées les unes aux autres, formant l'écran 2 du volet roulant 3, et guidées par deux coulisses latérales 6, représentées uniquement à la figure 2. Ces lames sont jointives lorsque le tablier 2 du volet roulant 3 atteint sa position basse déroulée.

Dans le cas d'un volet roulant, la position haute enroulée correspond à la mise en appui d'une lame d'extrémité finale 8, par exemple en forme de L, du tablier 2 du volet roulant 3 contre un bord d'un coffre 9 du volet roulant 3 ou à l'arrêt de la lame d'extrémité finale 8 dans une position de fin de course haute programmée. En outre, la position basse déroulée correspond à la mise en appui de la lame d'extrémité finale 8 du tablier 2 du volet roulant 3 contre un seuil 7 de l'ouverture 1 ou à l'arrêt de la lame d'extrémité finale 8 dans une position de fin de course basse programmée.

Ici, l'écran 2 est configuré pour être déplacé, au moyen du dispositif d'entraînement motorisé 5, entre une position ouverte, correspondant à la position enroulée et pouvant également être appelée première position de fin de course ou position de fin de course haute FdCH, et une position fermée, correspondant à la position déroulée et pouvant également être appelée deuxième position de fin de course ou position de fin de course basse FdCB.

Ainsi, l'actionneur électromécanique 11 est configuré pour entraîner, autrement dit entraîne, en déplacement l'écran 2, entre la première position de fin de course FdCH et la deuxième position de fin de course FdCB, et inversement. On distingue donc un déplacement en montée de l'écran 2, de la position FdCB vers la position FdCH, et un déplacement en descente de l'écran, de la position FdCH vers la position FdCB.

La première lame du volet roulant 3, opposée à la lame d'extrémité finale 8, est reliée au tube d'enroulement 4 au moyen d'au moins une articulation 10, en particulier une pièce d'attache en forme de bande.

Le tube d'enroulement 4 est disposé à l'intérieur du coffre 9 du volet roulant 3. Le tablier 2 du volet roulant 3 s'enroule et se déroule autour du tube d'enroulement 4 et est logé au moins en partie à l'intérieur du coffre 9.

De manière générale, le coffre 9 est disposé au-dessus de l'ouverture 1, ou encore en partie supérieure de l'ouverture 1.

Avantageusement, le dispositif d'entraînement motorisé 5 est commandé par une unité de commande. L'unité de commande peut être, par exemple, une unité de commande locale 12 ou une unité de commande centrale 13.

Avantageusement, l'unité de commande locale 12 peut être reliée, en liaison filaire ou non filaire, avec l'unité de commande centrale 13.

Avantageusement, l'unité de commande centrale 13 peut piloter l'unité de commande locale 12, ainsi que d'autres unités de commande locales similaires et réparties dans le bâtiment.

Le dispositif d'entraînement motorisé 5 est, de préférence, configuré pour exécuter les commandes de déroulement ou d'enroulement de l'écran 2 du dispositif d'occultation 3, pouvant être émises, notamment, par l'unité de commande locale 12 ou l'unité de commande centrale 13.

L'installation domotique 100 comprend soit l'unité de commande locale 12, soit l'unité de commande centrale 13, soit l'unité de commande locale 12 et l'unité de commande centrale 13.

On décrit à présent, plus en détail et en référence à la figure 3, le dispositif d'entraînement motorisé 5, y compris l'actionneur électromécanique 11, appartenant à l'installation domotique 100 et, plus particulièrement, au dispositif d'occultation 3 illustré aux figures 1 et 2.

L'actionneur électromécanique 11 comprend un moteur électrique 16.

Le moteur électrique 16 est représenté par son enveloppe à la figure 3, sans détails sur ses éléments constitutifs internes.

Avantageusement, le moteur électrique 16 comprend un rotor et un stator, non représentés et positionnés de manière coaxiale autour de l'axe de rotation X, qui est également l'axe de rotation du tube d'enroulement 4 en configuration montée du dispositif d'entraînement motorisé 5.

Ici, le moteur électrique 16 peut être de type sans balais à commutation électronique, appelé également « BLDC » (acronyme du terme anglo-saxon BrushLess Direct Current) ou « synchrone à aimants permanents », ou du type à courant continu.

Des moyens de commande de l'actionneur électromécanique 11, permettant le déplacement de l'écran 2 du dispositif d'occultation 3, comprennent au moins une unité électronique de contrôle 15. Cette unité électronique de contrôle 15 est apte à mettre en fonctionnement le moteur électrique 16 de l'actionneur électromécanique 11 et, en particulier, permettre l'alimentation en énergie électrique du moteur électrique 16.

Ainsi, l'unité électronique de contrôle 15 commande, notamment, le moteur électrique 16, de sorte à ouvrir ou fermer l'écran 2, comme décrit précédemment.

Les moyens de commande de l'actionneur électromécanique 11 comprennent des moyens matériels et/ou logiciels.

À titre d'exemple nullement limitatif, les moyens matériels peuvent comprendre au moins un microcontrôleur 31.

Ici, le dispositif d'entraînement motorisé 5 comprend l'unité électronique de contrôle 15. En outre, l'unité électronique de contrôle 15 comprend le microcontrôleur 31.

Avantageusement, l'unité électronique de contrôle 15 comprend, en outre, un premier module de communication 27, en particulier de réception d'ordres de commande, les ordres de commande étant émis par un émetteur d'ordres, tel que l'unité de commande locale 12 ou l'unité de commande centrale 13, ces ordres étant destinés à commander le dispositif d'entraînement motorisé 5.

Avantageusement, le premier module de communication 27 de l'unité électronique de contrôle 15 est de type sans fil. En particulier, le premier module de communication 27 est configuré pour recevoir des ordres de commande radioélectriques.

Avantageusement, le premier module de communication 27 peut également permettre la réception d'ordres de commande transmis par des moyens filaires.

Avantageusement, l'unité électronique de contrôle 15, l'unité de commande locale 12 et/ou l'unité de commande centrale 13 peuvent être en communication avec une station météorologique, non représentée, disposée à l'intérieur du bâtiment ou déportée à l'extérieur du bâtiment, incluant, notamment, un ou plusieurs capteurs pouvant être configurés pour déterminer, par exemple, une température, une luminosité, ou encore une vitesse de vent, dans le cas où la station météorologique est déportée à l'extérieur du bâtiment.

Avantageusement, l'unité électronique de contrôle 15, l'unité de commande locale 12 et/ou l'unité de commande centrale 13 peuvent également être en communication avec un serveur 28, tel qu'illustré à la figure 2, de sorte à contrôler l'actionneur électromécanique 11 suivant des données mises à disposition à distance par l'intermédiaire d'un réseau de communication, en particulier un réseau internet pouvant être relié au serveur 28.

L'unité électronique de contrôle 15 peut être commandée à partir de l'unité de commande locale 12 et/ou centrale 13. L'unité de commande locale 12 et/ou centrale 13 est pourvue d'un clavier de commande. Le clavier de commande de l'unité de commande locale 12 ou centrale 13 comprend un ou plusieurs éléments de sélection 14 et, éventuellement, un ou plusieurs éléments d'affichage 34.

À titre d'exemples nullement limitatifs, les éléments de sélection peuvent comprendre des boutons poussoirs et/ou des touches sensitives. Les éléments d'affichage peuvent comprendre des diodes électroluminescentes et/ou un afficheur LCD (acronyme du terme anglo-saxon « Liquid Crystal Display ») ou TFT (acronyme du terme anglo-saxon « Thin Film Transistor »). Les éléments de sélection et d'affichage peuvent être également réalisés au moyen d'un écran tactile.

Avantageusement, l'unité de commande locale 12 et/ou centrale 13 comprend au moins un deuxième module de communication 36.

Ainsi, le deuxième module de communication 36 de l'unité de commande locale 12 ou centrale 13 est configuré pour émettre, autrement dit émet, des ordres de commande, en particulier par des moyens sans fil, par exemple radioélectriques, ou par des moyens filaires.

En outre, le deuxième module de communication 36 de l'unité de commande locale 12 ou centrale 13 peut également être configuré pour recevoir, autrement dit reçoit, des ordres de commande, en particulier par l'intermédiaire des mêmes moyens.

Avantageusement, le deuxième module de communication 36 de l'unité de commande locale 12 ou centrale 13 est configuré pour communiquer, autrement dit communique, avec le premier module de communication 27 de l'unité électronique de contrôle 15.

Ainsi, le deuxième module de communication 36 de l'unité de commande locale 12 ou centrale 13 échange des ordres de commande avec le premier module de communication 27 de l'unité électronique de contrôle 15, soit de manière monodirectionnelle, soit de manière bidirectionnelle.

Avantageusement, l'unité de commande locale 12 est un point de commande, pouvant être fixe ou nomade. Un point de commande fixe peut être un boîtier de commande destiné à être fixé sur une façade d'un mur du bâtiment ou sur une face d'un cadre dormant de la fenêtre 40 ou d'une porte. Un point de commande nomade peut être une télécommande, un téléphone intelligent ou une tablette.

Avantageusement, l'unité de commande locale 12 et/ou centrale 13 comprend, en outre, un contrôleur 35.

Le dispositif d'entraînement motorisé 5, en particulier l'unité électronique de contrôle 15, est, de préférence, configuré pour exécuter des ordres de commande de déplacement, notamment de fermeture ainsi que d'ouverture, de l'écran 2 du dispositif d'occultation 3. Ces ordres de commande peuvent être émis, notamment, par l'unité de commande locale 12 ou par l'unité de commande centrale 13.

Le dispositif d'entraînement motorisé 5 peut être contrôlé par l'utilisateur, par exemple par la réception d'un ordre de commande correspondant à un appui sur le ou l'un des éléments de sélection 14 de l'unité de commande locale 12 ou centrale 13.

Le dispositif d'entraînement motorisé 5 peut également être contrôlé automatiquement, par exemple par la réception d'un ordre de commande correspondant à au moins un signal provenant d'au moins un capteur, non représenté, et/ou à un signal provenant d'une horloge, non représentée, de l'unité électronique de contrôle 15, en particulier du microcontrôleur 31. Le capteur et/ou l'horloge peuvent, en variante, être intégrés à l'unité de commande locale 12 ou à l'unité de commande centrale 13.

Avantageusement, l'actionneur électromécanique 11 comprend, en outre, un carter 17, en particulier tubulaire. Le moteur électrique 16 est monté à l'intérieur du carter 17, en particulier dans une configuration assemblée de l'actionneur électromécanique 11.

Ici, le carter 17 de l'actionneur électromécanique 11 est de forme cylindrique, notamment de révolution autour de l'axe de rotation X.

Avantageusement, le carter 17 est un tube.

Ici, le tube formant le carter 17 présente une section circulaire.

Dans un exemple de réalisation, le carter 17 est réalisé dans un matériau métallique.

La matière du carter de l'actionneur électromécanique n'est pas limitative et peut être différente. Il peut s'agir, en particulier, d'une matière plastique.

Le carter 17 est creux. Le carter 17 comprend une première extrémité 17a et une deuxième extrémité 17b. La deuxième extrémité 17b est opposée à la première extrémité 17a. Le carter 17 est ouvert à chacune de ses extrémités 17a, 17b.

Avantageusement, l'actionneur électromécanique 11 comprend, en outre, un arbre de sortie 20.

L'arbre de sortie 20 est disposé, autrement dit est configuré pour être disposé, au niveau de la deuxième extrémité 17b du carter 17, en particulier dans la configuration assemblée de l'actionneur électromécanique 11.

Avantageusement, l'actionneur électromécanique 11 comprend, en outre, un réducteur 19.

Le réducteur 19 est représenté par son enveloppe à la figure 3, sans détails sur ses éléments constitutifs internes.

Avantageusement, le réducteur 19 comprend au moins un étage de réduction. L'étage de réduction peut être un train d'engrenages de type épicycloïdal.

Le type et le nombre d'étages de réduction du réducteur ne sont pas limitatifs.

Le réducteur 19 est accouplé, autrement dit est configuré pour être accouplé, avec le moteur électrique 16, en particulier avec le rotor du moteur électrique 16, dans la configuration assemblée de l'actionneur électromécanique 11.

Avantageusement, l'actionneur électromécanique 11 comprend, en outre, un frein 29.

À titre d'exemples nullement limitatifs, le frein 29 peut être un frein à ressort, un frein à came, un frein magnétique ou un frein électromagnétique.

Ici et comme visible à la figure 3, en particulier dans la configuration assemblée de l'actionneur électromécanique 11, le frein 29 est configuré pour être disposé, autrement dit est disposé, entre le moteur électrique 16 et le réducteur 19, c'est-à-dire à la sortie du moteur électrique 16.

En variante, non représentée, le frein 29 est configuré pour être disposé, autrement dit est disposé, en particulier dans la configuration assemblée de l'actionneur électromécanique 11, entre l'unité électronique de contrôle 15 et le moteur électrique 16, autrement dit à l'entrée du moteur électrique 16, entre le réducteur 19 et l'arbre de sortie 20, autrement dit à la sortie du réducteur 19, ou entre deux étages de réduction du réducteur 19.

Avantageusement, le réducteur 19 et, éventuellement, le frein 29 sont disposés à l'intérieur du carter 17 de l'actionneur électromécanique 11, en particulier dans la configuration assemblée de l'actionneur électromécanique 11.

Avantageusement, l'actionneur électromécanique 11 comprend, en outre, une couronne 30. La couronne 30 est disposée, autrement dit est configurée pour être disposée, au niveau de la première extrémité 17a du carter 17, en particulier dans la configuration assemblée de l'actionneur électromécanique 11.

La couronne 30 constitue, autrement dit est configurée pour constituer, un palier de guidage en rotation du tube d'enroulement 4, en particulier dans une configuration assemblée du dispositif d'occultation 3.

Avantageusement, l'actionneur électromécanique 11 et, plus particulièrement, l'unité électronique de contrôle 15 comprend, en outre, un dispositif, non représenté, de détection d'obstacle et de fins de course, lors de l'enroulement de l'écran 2 et lors du déroulement de cet écran 2, ce dispositif pouvant être mécanique ou électronique.

Avantageusement, le dispositif de détection d'obstacle et de fins de course est mis en oeuvre au moyen du microcontrôleur 31 de l'unité électronique de contrôle 15 et, en particulier, au moyen d'un algorithme mis en oeuvre par ce microcontrôleur 31.

Le tube d'enroulement 4 est entraîné en rotation autour de l'axe de rotation X et autour du carter 17 de l'actionneur électromécanique 11 en étant soutenu par l'intermédiaire de deux liaisons pivot. La première liaison pivot est réalisée au niveau d'une première extrémité du tube d'enroulement 4 au moyen de la couronne 30 insérée autour de la première extrémité 17a du carter 17 de l'actionneur électromécanique 11. La couronne 30 permet ainsi de réaliser un palier. La deuxième liaison pivot, non représentée à la figure 3, est réalisée au niveau d'une deuxième extrémité du tube d'enroulement 4, non visible sur cette figure.

Avantageusement, l'actionneur électromécanique 11 comprend, en outre, un support de couple 21, pouvant également être appelé « tête d'actionneur » ou « point fixe ».

Le support de couple 21 obture, autrement dit est configuré pour obturer, la première extrémité 17a du carter 17, en particulier dans la configuration assemblée de l'actionneur électromécanique 11.

Ainsi, le support de couple 21 est disposé, autrement dit est configuré pour être disposé, au niveau de la première extrémité 17a du carter 17.

Avantageusement, le support de couple 21 est en saillie, au niveau de la première extrémité 17a du carter 17, en particulier l'extrémité 17a du carter 17 recevant la couronne 30.

Ainsi, une première partie du support de couple 21 est disposée à l'intérieur du carter 17 et une deuxième partie du support de couple 21 est disposée à l'extérieur du carter 17.

Avantageusement, le support de couple 21 de l'actionneur électromécanique 11 est configuré pour fixer l'actionneur électromécanique 11 sur un bâti 23, en particulier sur une joue du coffre 9.

Ainsi, le support de couple 21 permet de reprendre les efforts exercés par l'actionneur électromécanique 11, en particulier le couple exercé par l'actionneur électromécanique 11, par rapport à la structure du bâtiment. Le support de couple 21 permet avantageusement de reprendre, en outre, des efforts exercés par le tube d'enroulement 4, notamment le poids du tube d'enroulement 4, de l'actionneur électromécanique 11 et de l'écran 2, et d'assurer la reprise de ces efforts par la structure du bâtiment.

Le support de couple 21 est fixé, autrement dit est configuré pour être fixé, au carter 17 au moyen d'un ou plusieurs éléments de fixation, en particulier dans la configuration assemblée de l'actionneur électromécanique 11. Le ou les éléments de fixation peuvent être, notamment, des bossages, des vis de fixation, des éléments de fixation par encliquetage élastique, des nervures emmanchées dans des échancrures ou une combinaison de ces différents éléments de fixation.

Par ailleurs, le support de couple 21 de l'actionneur électromécanique 11 peut permettre de supporter au moins une partie de l'unité électronique de contrôle 15.

Avantageusement, l'unité électronique de contrôle 15 peut être alimentée en énergie électrique au moyen d'un câble d'alimentation électrique 18.

Ici et tel qu'illustré à la figure 3, l'unité électronique de contrôle 15 est ainsi disposée, autrement dit est intégrée, à l'intérieur du carter 17 de l'actionneur électromécanique 11.

En variante, non représentée, l'unité électronique de contrôle 15 est disposée à l'extérieur du carter 17 de l'actionneur électromécanique 11 et, en particulier, montée sur le coffre 9 ou dans le support de couple 21.

Avantageusement, le support de couple 21 peut comprendre au moins un bouton, non représenté.

Ce ou ces boutons peuvent permettre de réaliser un réglage de l'actionneur électromécanique 11 au travers d'un ou plusieurs modes de configuration, d'appairer avec l'actionneur électromécanique 11 une ou plusieurs unités de commande 12, 13, de réinitialiser un ou plusieurs paramètres, pouvant être, par exemple, une position de fin de course, de réinitialiser la ou les unités de commande 12, 13 appairées ou encore de commander le déplacement de l'écran 2.

Avantageusement, le dispositif d'entraînement motorisé 5 comprend au moins un dispositif d'affichage 38, représenté uniquement à la figure 2, de sorte à permettre une indication visuelle d'un paramètre de fonctionnement du dispositif d'entraînement motorisé 5.

Ici, le dispositif d'affichage 38 est déporté sur un produit électronique, comme par exemple l'unité de commande locale 12, l'unité de commande centrale 13, ou encore un boîtier domotique 56, tel que, par exemple, un outil de configuration, ou un téléphone intelligent.

Ce dispositif d'affichage 38 peut être en complément ou en remplacement de l'élément d'affichage 34.

En variante, non représentée, le dispositif d'affichage 38 est disposé sur un autre élément de l'installation domotique 100, comme par exemple sur le coffre 9, sur un mur du bâtiment, sur l'une des coulisses latérales 6, sur une vitre de la fenêtre 40 ou sur un cadre dormant de la fenêtre 40.

Selon une autre variante, non représentée, le dispositif d'affichage 38 est disposé sur le support de couple 21.

En variante, le dispositif d'affichage 38 comprend au moins une source d'éclairage 39, en particulier une diode électroluminescente.

Cette ou ces sources d'éclairage 39 peuvent être montées sur une carte électronique, non représentée, de l'unité électronique de contrôle 15 et, éventuellement, un capot transparent ou translucide et/ou un guide de lumière est ou sont prévus, pour permettre le passage de la lumière émise par la ou chacune des sources d'éclairage 39.

Avantageusement, l'arbre de sortie 20 de l'actionneur électromécanique 11 est disposé à l'intérieur du tube d'enroulement 4 et au moins en partie à l'extérieur du carter 17 de l'actionneur électromécanique 11.

Ici, une extrémité de l'arbre de sortie 20 est en saillie par rapport au carter 17 de l'actionneur électromécanique 11, en particulier par rapport à la deuxième extrémité 17b du carter 17 opposée à la première extrémité 17a.

Avantageusement, l'arbre de sortie 20 de l'actionneur électromécanique 11 est configuré pour entraîner en rotation un élément de liaison 22. Cet élément de liaison 22 est relié au tube d'enroulement 4, en particulier dans la configuration assemblée du dispositif d'occultation 3. L'élément de liaison est, dans l'exemple des figures, réalisé sous la forme d'une roue.

Lors de la mise en fonctionnement de l'actionneur électromécanique 11, le moteur électrique 16 et le réducteur 19 entraînent en rotation l'arbre de sortie 20. En outre, l'arbre de sortie 20 de l'actionneur électromécanique 11 entraîne en rotation le tube d'enroulement 4 par l'intermédiaire de l'élément de liaison 22.

Ainsi, le tube d'enroulement 4 entraîne en rotation l'écran 2 du dispositif d'occultation 3, de sorte à ouvrir ou fermer l'ouverture 1.

On note R la vitesse de rotation du moteur électrique 16, exprimée en tours par minute.

Cette vitesse de rotation R permet de définir la vitesse de rotation de l'arbre de sortie 20 de l'actionneur électromécanique 11, ainsi que celle du tube d'enroulement 4.

En pratique, la vitesse de rotation de l'arbre de sortie 20 de l'actionneur électromécanique 11, ainsi que celle du tube d'enroulement 4 s'obtient en multipliant la vitesse de rotation R du moteur électrique 16 avec le rapport de réduction du réducteur 19.

Avantageusement, l'actionneur électromécanique 11 comprend, en outre, un dispositif de mesure, non représenté, de la vitesse de rotation R.

Avantageusement, le dispositif d'entraînement motorisé 5 et, plus particulièrement, l'actionneur électromécanique 11 peut comprendre un dispositif de comptage, non représenté, pouvant notamment être utilisé pour déterminer la vitesse de rotation R du moteur électrique 16. Le dispositif de comptage est configuré pour coopérer avec l'unité électronique de contrôle 15. En outre, le dispositif de comptage et l'unité électronique de contrôle 15 sont configurés pour déterminer une position, pouvant être appelée « courante », de l'écran 2, et, par conséquent, la vitesse de rotation R du moteur électrique 16, ainsi que celle de l'arbre de sortie 20 de l'actionneur électromécanique 11 et celle du tube d'enroulement 4.

Avantageusement, le dispositif de comptage comprend au moins un capteur, en particulier de position, pouvant être, par exemple, au nombre de un, deux ou trois.

Dans un exemple de réalisation, le dispositif de comptage est de type magnétique, par exemple un encodeur équipé d'un ou plusieurs capteurs à effet Hall.

Dans un exemple de réalisation, le dispositif de comptage permet de déterminer le nombre de tours réalisés par le rotor du moteur électrique 16.

En variante, non représentée, le dispositif de comptage permet de déterminer le nombre de tours réalisés par l'arbre de sortie 20 de l'actionneur électromécanique 11.

Le type de dispositif de comptage n'est pas limitatif et peut être différent. Ce dispositif de comptage peut, en particulier, être de type optique, par exemple un encodeur équipé d'un ou plusieurs capteurs optiques, ou de type temporel, par exemple une horloge du microcontrôleur 31.

Le dispositif d'occultation 3 et, plus particulièrement, le dispositif d'entraînement motorisé 5 comprend, en outre, un dispositif d'alimentation en énergie électrique 26, visible à la figure 2. L'actionneur électromécanique 11 est relié électriquement au dispositif d'alimentation en énergie électrique 26.

Le dispositif d'alimentation en énergie électrique 26 comprend au moins une batterie 24.

La batterie 24 fournit, autrement dit est configuré pour fournir ou délivrer, une tension V_{bat}.

On note Rᵢₙₜ la résistance interne de la batterie 24.

Avantageusement, le dispositif d'alimentation en énergie électrique 26 comprend, en outre, au moins un panneau photovoltaïque 25.

Le panneau photovoltaïque 25 fournit, autrement dit est configuré pour fournir ou délivrer, une tension Vₚᵥ.

Le panneau photovoltaïque 25 fournit, autrement dit est configuré pour fournir ou délivrer, en outre, un courant électrique d'une intensité Iₚᵥ.

Avantageusement, le panneau photovoltaïque 25 peut être fixé sur le coffre 9, sur un mur du bâtiment, sur l'une des coulisses latérales 6, sur une vitre de la fenêtre 40 ou sur un cadre dormant de la fenêtre 40.

Le dispositif d'alimentation en énergie électrique 26 est configuré pour alimenter, autrement dit alimente, en énergie électrique l'actionneur électromécanique 11 et, plus particulièrement, l'unité électronique de contrôle 15 et le moteur électrique 16.

Ainsi, le dispositif d'alimentation en énergie électrique 26 permet d'alimenter en énergie électrique l'actionneur électromécanique 11, sans être lui-même relié électriquement à un réseau d'alimentation électrique du secteur.

Ici, le panneau photovoltaïque 25 est relié électriquement à la batterie 24, par une liaison électrique.

L'actionneur électromécanique 11 est relié électriquement au dispositif d'alimentation en énergie électrique 26 et, plus particulièrement, à la batterie 24, en particulier au moyen du câble d'alimentation électrique 18.

La batterie 24 est configurée pour alimenter, autrement dit alimente, en énergie électrique l'actionneur électromécanique 11, en particulier l'unité électronique de contrôle 15 et le moteur électrique 16.

Avantageusement, la batterie 24 est configurée pour être alimentée, autrement dit est alimentée, en énergie électrique par le panneau photovoltaïque 25.

Ainsi, le rechargement de la batterie 24 est mis en oeuvre par énergie solaire, au moyen du panneau photovoltaïque 25.

Avantageusement, la batterie 24 peut être disposée au niveau du coffre 9 du dispositif d'occultation 3.

Ici et comme illustré à la figure 2, la batterie 24 est disposée à l'extérieur du coffre 9.

En variante, non représentée, la batterie 24 peut être disposée à l'intérieur du coffre 9, à l'intérieur du tube d'enroulement 4 tout en étant à l'extérieur du carter 17, ou à l'intérieur du carter 17, en particulier dans la configuration assemblée de l'actionneur électromécanique 11. Dans ce dernier cas, l'actionneur électromécanique 11 comprend la batterie 24.

Le dispositif d'affichage 38 permet de visualiser au moins un indicateur représentatif de l'autonomie de la batterie 24. Cet indicateur s'exprime, de préférence, en un nombre de cycles de déplacement de l'écran 2 pouvant être exécutés par l'actionneur électromécanique 11, c'est-à-dire que le dispositif d'affichage 38 indique combien de cycles de déplacement de l'écran 2 peuvent être exécutés en fonction de l'autonomie de la batterie 24. En d'autres termes, cet indicateur est un indicateur fonctionnel, plutôt qu'un indicateur de charge. Il est noté « SOF », de l'acronyme de l'expression anglaise "State Of Function", signifiant « état de fonctionnement » en français. L'indicateur SOF est établi au cours du procédé de commande décrit ci-après.

L'indicateur SOF s'exprime, par exemple, de façon numéraire, en affichant sur le dispositif d'affichage 38 un chiffre correspondant au nombre de cycles de déplacement de l'écran 2 pouvant être exécutés par l'actionneur électromécanique 11, ou s'exprime en indiquant une plage d'autonomie estimée, par exemple, une autonomie restante définie par une plage de nombres de cycles de déplacement de l'écran 2 pouvant être exécutés par l'actionneur électromécanique 11.

Selon une autre approche, l'indicateur SOF s'exprime de manière visuelle, à l'aide de la source d'éclairage 39 du dispositif d'affichage 38. Par exemple, la source d'éclairage 39 est prévue pour pouvoir afficher plusieurs couleurs, telles que du vert, du jaune, de l'orange et du rouge, et chaque couleur correspond à une plage d'indicateur, autrement dit à un état de fonctionnement du dispositif d'entraînement motorisé 5.

A titre d'exemple nullement limitatif, la couleur rouge peut être utilisée pour un indicateur SOF correspondant à une autonomie estimée nulle, c'est-à-dire que le dispositif d'entraînement motorisé 5 ne peut plus exécuter un déplacement complet de l'écran 2, la coureur orange peut être utilisée pour une autonomie estimée entre 1 et 5 cycles de déplacement de l'écran 2, la couleur jaune peut être utilisée pour une autonomie estimée entre 6 et 15 cycles de déplacement de l'écran 2 et la couleur verte peut être utilisée pour une autonomie estimée supérieure à 15 cycles de déplacement de l'écran 2. Dans cet exemple, l'indicateur SOF peut donc prendre quatre états, correspondants à quatre couleurs.

Selon une autre approche, l'indicateur SOF peut prendre deux états, correspondants à deux couleurs émises par la source d'éclairage 39 du dispositif d'affichage 38, tels que du vert et du rouge. La couleur verte est, par exemple, utilisée lorsque l'autonomie estimée est strictement supérieure à 1 cycle et la couleur rouge est alors utilisée lorsque l'autonomie est inférieure ou égale à 1 cycle.

En variante, les deux états correspondent à un état allumé et à un état éteint de la source d'éclairage 39 du dispositif d'affichage 38.

En variante, l'indicateur SOF peut prendre un nombre d'états différent, par exemple trois états ou plus de quatre états.

Ici, l'actionneur électromécanique 11 comprend le câble d'alimentation électrique 18 permettant son alimentation en énergie électrique, notamment l'alimentation électrique de l'unité électronique de contrôle 15 et l'alimentation électrique du moteur électrique 16, en particulier à partir de la batterie 24.

Ici, la batterie 24 est reliée électriquement directement à l'unité électronique de contrôle 15, par le câble d'alimentation électrique 18.

La batterie 24 est de type rechargeable.

Avantageusement, la batterie 24 comprend une pluralité d'éléments de stockage d'énergie 32, en particulier reliés électriquement en série. Les éléments de stockage d'énergie 32 de la batterie 24 peuvent être, notamment, des piles, autrement dit des accumulateurs.

Avantageusement, le panneau photovoltaïque 25 comprend une pluralité de cellules photovoltaïques 43. Dans ce cas, la batterie 24 est alimentée en énergie électrique au moyen des cellules photovoltaïques 43 du panneau photovoltaïque 25.

Le dispositif d'entraînement motorisé 5, en particulier le panneau photovoltaïque 25 et/ou l'unité électronique de contrôle 15, comprend des éléments de chargement configurés pour charger la batterie 24, à partir de l'énergie solaire récupérée par le panneau photovoltaïque 25. Dans ce cas, le courant circule entre les composants 15, 24 et 25 à travers une liaison filaire, pouvant être distincte du câble d'alimentation en énergie électrique 18.

Ainsi, les éléments de chargement configurés pour charger la batterie 24, à partir de l'énergie solaire, permettent de convertir l'énergie solaire récupérée par le panneau photovoltaïque 25 en énergie électrique.

En variante, en complément, le dispositif d'entraînement motorisé 5, en particulier l'actionneur électromécanique 11, est alimenté en énergie électrique à partir de la batterie 24, à partir d'une batterie auxiliaire, non représentée, ou à partir d'un réseau d'alimentation électrique du secteur, en particulier par le réseau alternatif commercial, notamment en fonction d'un état de charge de la batterie 24.

Ici, l'unité électronique de contrôle 15 comprend une seule carte électronique 55. En outre, la carte électronique 55 est configurée pour contrôler le moteur électrique 16, pour permettre la recharge de la batterie 24 et, éventuellement, accéder à des fonctions de paramétrage et/ou de configuration de l'actionneur électromécanique 11, au moyen d'éléments de sélection et, éventuellement, d'affichage, non représentés. Comme mentionné ci-dessus, les éléments de chargement de la batterie 24 peuvent être disposés au niveau de la carte électronique 55.

En variante, non représentée, l'unité électronique de contrôle 15 comprend une première carte électronique et une deuxième carte électronique. La première carte électronique est configurée pour contrôler, autrement dit contrôle, le moteur électrique 16. En outre, la deuxième carte électronique est configurée pour permettre la recharge de la batterie 24 et, éventuellement, accéder à des fonctions de paramétrage et/ou de configuration de l'actionneur électromécanique 11, au moyen d'éléments de sélection et, éventuellement, d'affichage, non représentés. Les éléments de chargement de la batterie 24 peuvent être disposés au niveau de la deuxième carte électronique.

Dans le cas où l'unité électronique de contrôle 15 comprend une première carte électronique et une deuxième carte électronique, non représentées, la première carte électronique de l'unité électronique de contrôle 15 peut être disposée à l'intérieur du carter 17 de l'actionneur électromécanique 11. En outre, la deuxième carte électronique peut être disposée à l'intérieur du support de couple 21 de l'actionneur électromécanique 11. Par ailleurs, le support de couple 21 peut comprendre un couvercle, non représenté. En outre, la deuxième carte électronique peut être disposée à l'intérieur d'un logement formé entre une partie du support de couple 21 et le couvercle.

L'unité électronique de contrôle 15 comprend, en outre, au moins un dispositif de mesure 33.

Le dispositif de mesure 33 est configuré pour mesurer, autrement dit mesure, la tension V_{bat} fournie ou délivrée par la batterie 24, comme illustré à la figure 3.

Le dispositif de mesure 33 est relié électriquement à la batterie 24.

Le microcontrôleur 31 comprend au moins un premier port d'entrée, non représenté, de lecture de la tension V_{bat} fournie par la batterie 24 et mesurée par le dispositif de mesure 33. Autrement dit, le premier port d'entrée du microcontrôleur 31 est configuré pour lire la tension V_{bat} fournie par la batterie 24 et mesurée par le dispositif de mesure 33.

Avantageusement, le premier port d'entrée du microcontrôleur 31 comprend un premier convertisseur analogique/numérique, non représenté. Dans ce cas, le premier convertisseur analogique/numérique est intégré au microcontrôleur 31.

En variante, non représentée, le premier port d'entrée du microcontrôleur 31 est relié électriquement à un premier convertisseur analogique/numérique. Dans ce cas, le premier convertisseur analogique/numérique est un élément distinct du microcontrôleur 31.

Avantageusement, le dispositif de mesure 33 comprend au moins un premier pont diviseur de tension, non représenté.

Ici, le premier pont diviseur de tension comprend une première résistance et une deuxième résistance. La première résistance est reliée électriquement à la deuxième résistance. Le premier pont diviseur de tension comprend un premier point milieu. Le premier point milieu est situé entre la première résistance et la deuxième résistance.

Ainsi, les première et deuxième résistances du premier pont diviseur de tension permettent de mesurer, autrement dit de déterminer, une valeur de la tension V_{bat} fournie par la batterie 24.

Avantageusement, le dispositif de mesure 33 est également configuré pour mesurer, autrement dit mesure, l'intensité Iₚᵥ du courant électrique fourni ou délivré par le panneau photovoltaïque 25.

Le dispositif de mesure 33 est relié électriquement au panneau photovoltaïque 25.

Le microcontrôleur 31 comprend au moins un deuxième port d'entrée, non représenté, de lecture de l'intensité Iₚᵥ du courant électrique délivré par le panneau photovoltaïque 25 et mesurée par le dispositif de mesure 33. Autrement dit, le deuxième port d'entrée du microcontrôleur 31 est configuré pour lire l'intensité Iₚᵥ du courant électrique délivré par le panneau photovoltaïque 25 et mesurée par le dispositif de mesure 33.

Avantageusement, le deuxième port d'entrée du microcontrôleur 31 comprend un deuxième convertisseur analogique/numérique, non représenté. Dans ce cas, le deuxième convertisseur analogique/numérique est intégré au microcontrôleur 31.

En variante, non représentée, le deuxième port d'entrée du microcontrôleur 31 est relié électriquement à un deuxième convertisseur analogique/numérique. Dans ce cas, le deuxième convertisseur analogique/numérique est un élément distinct du microcontrôleur 31.

Avantageusement, le dispositif de mesure 33 comprend au moins une résistance de shunt, non représentée, et, éventuellement, un amplificateur, non représenté.

Ainsi, la résistance de shunt permet de mesurer, autrement dit de déterminer, une valeur de l'intensité Iₚᵥ du courant électrique délivré par le panneau photovoltaïque 25.

Avantageusement, le dispositif de mesure 33 est également configuré pour mesurer, autrement dit mesure, la tension Vₚᵥ fournie ou délivrée par le panneau photovoltaïque 25.

Le dispositif de mesure 33 est relié électriquement au panneau photovoltaïque 25.

Le microcontrôleur 31 comprend au moins un troisième port d'entrée, non représenté, de lecture de de la tension Vₚᵥ fournie par le panneau photovoltaïque 25 et mesurée par le dispositif de mesure 33. Autrement dit, le troisième port d'entrée du microcontrôleur 31 est configuré pour lire la tension Vₚᵥ fournie par le panneau photovoltaïque 25 et mesurée par le dispositif de mesure 33.

Avantageusement, le troisième port d'entrée du microcontrôleur 31 comprend un troisième convertisseur analogique/numérique, non représenté. Dans ce cas, le troisième convertisseur analogique/numérique est intégré au microcontrôleur 31.

En variante, non représentée, le troisième port d'entrée du microcontrôleur 31 est relié électriquement à un troisième convertisseur analogique/numérique. Dans ce cas, le troisième convertisseur analogique/numérique est un élément distinct du microcontrôleur 31.

Avantageusement, le dispositif de mesure 33 comprend au moins un deuxième pont diviseur de tension, non représenté.

Ici, le deuxième pont diviseur de tension comprend une troisième résistance et une quatrième résistance. La troisième résistance est reliée électriquement à la quatrième résistance. Le deuxième pont diviseur de tension comprend un deuxième point milieu. Le deuxième point milieu est situé entre la troisième résistance et la quatrième résistance.

Ainsi, les troisième et quatrième résistances du deuxième pont diviseur de tension permettent de mesurer, autrement dit de déterminer, une valeur de la tension Vₚᵥ fournie par le panneau photovoltaïque 25.

Avantageusement, le dispositif d'alimentation en énergie électrique 26 et, plus particulièrement, l'unité électronique de contrôle 15 comprend, en outre, une diode, non représentée. La diode est reliée électriquement, d'une part, au panneau photovoltaïque 25 et, d'autre part, à la batterie 24.

Avantageusement, la diode fait partie intégrante de la liaison électrique entre le panneau photovoltaïque 25 et la batterie 24.

Ici, la diode est disposée entre le panneau photovoltaïque 25 et la batterie 24. La diode est dite « passante » du panneau photovoltaïque 25 vers la batterie 24 et dite « bloquante » de la batterie 24 vers le panneau photovoltaïque 25.

Ici, la diode permet, notamment, d'éviter un retour d'énergie électrique de la batterie 24 vers le panneau photovoltaïque 25, lorsque la valeur de la tension Vₚᵥ fournie par le panneau photovoltaïque 25 est strictement inférieure à une valeur de la tension V_{bat} fournie par la batterie 24.

En outre, la diode permet de protéger le dispositif d'alimentation en énergie électrique 26 par rapport à une inversion du sens de câblage de la batterie 24 ou du panneau photovoltaïque 25.

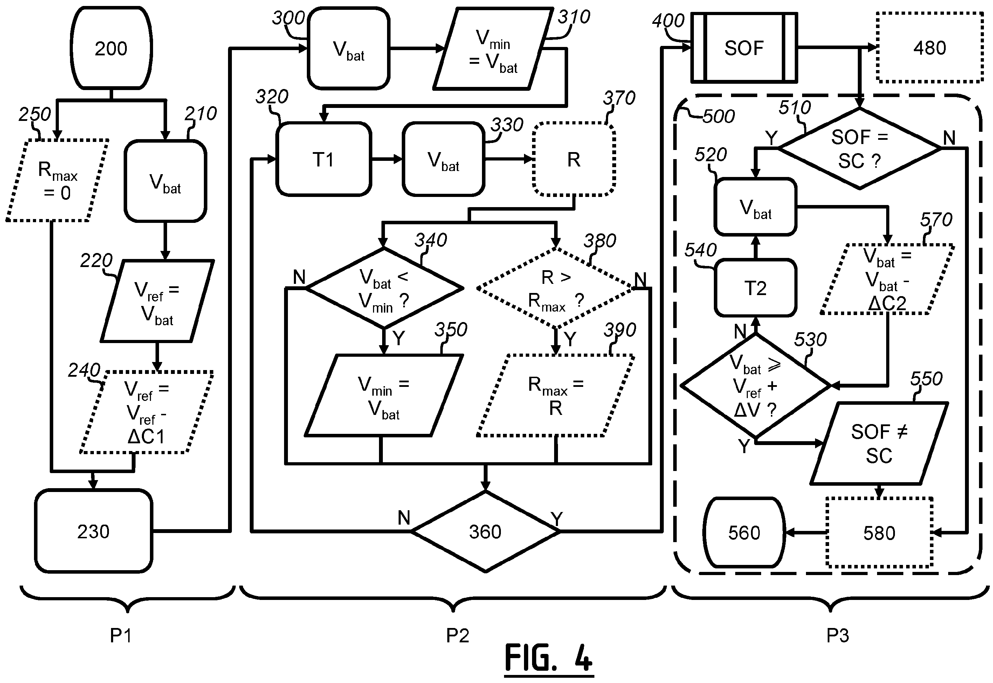

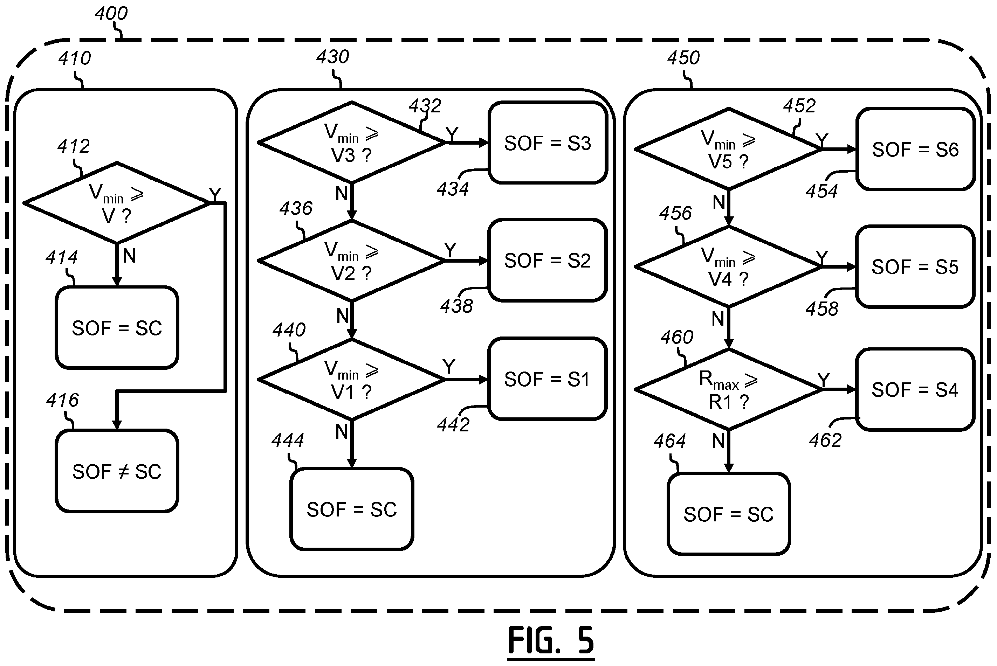

On décrit à présent, en référence aux figures 4 et 5, un mode d'exécution d'un procédé de commande en fonctionnement du dispositif d'entraînement motorisé 5, illustré aux figures 1 à 3, conforme à l'invention.

Le procédé vise à établir l'indicateur SOF représentatif de l'autonomie de la batterie 24, exprimée, par exemple, en un nombre de cycles de déplacement de l'écran 2 pouvant être exécutés par l'actionneur électromécanique 11.

Le procédé est exécuté automatiquement par l'unité électronique de contrôle 15, notamment lorsque l'unité électronique de contrôle 15 reçoit un ordre de commande provenant de l'unité de commande locale 12 ou centrale 13, ou encore d'un capteur et/ou d'une horloge.

Le procédé est exécuté lorsque l'ordre de commande reçu est un ordre de commande visant à entraîner un déplacement de l'écran 2 dans le mouvement nécessitant la puissance délivrée par l'actionneur électromécanique 11 la plus importante, parmi le déplacement en montée de l'écran 2 et le déplacement en descente de l'écran 2.

Dans l'exemple, le procédé est exécuté lorsque l'ordre de commande reçu est un ordre de déplacement en montée de l'écran 2, car ce déplacement nécessite, dans l'exemple, une puissance délivrée par l'actionneur électromécanique 11 supérieure au déplacement en descente de l'écran 2, ce dernier étant aidé par le poids propre de l'écran 2.

Avantageusement, le procédé comprend une phase d'initialisation P1, mise en oeuvre avant une période de fonctionnement du moteur électrique 16 et, de préférence, après la réception par l'unité électronique de contrôle 15 d'un ordre de commande, en particulier par le premier module de communication 27.

Avantageusement, le procédé comprend, au cours de la phase d'initialisation P1, une étape de démarrage 200, qui correspond au démarrage de la phase d'initialisation P1, déclenchée lors de la réception par l'unité électronique de contrôle 15 de l'ordre de commande, en particulier par le premier module de communication 27.

Le procédé comprend, en outre, au cours de la phase d'initialisation P1, une première étape de mesure 210, dite « de mesure préalable », dans le cas présent postérieure à l'étape de démarrage 200, qui consiste à mesurer la tension V_{bat} délivrée par la batterie 24, en particulier au moyen du dispositif de mesure 33. Cette mesure est dite « à vide », car elle s'effectue lorsque la batterie 24 ne fournit pas d'énergie électrique au moteur électrique 16.

Avantageusement, le procédé comprend, en outre, au cours de la phase d'initialisation P1, une première étape d'enregistrement 220, dite « d'enregistrement préalable », au cours de laquelle une valeur de la tension V_{bat} mesurée, lors de la première étape de mesure 210, est enregistrée comme étant une valeur de référence, notée V_{ref}, de la tension V_{bat}.

Avantageusement, le procédé comprend, en outre, au cours de la phase d'initialisation P1, une première étape de fin 230, qui consiste à autoriser le déplacement de l'écran 2 par l'actionneur électromécanique 11.

Le procédé comprend, en outre, une phase de mesure P2, mise en oeuvre simultanément au déplacement de l'écran 2, c'est-à-dire pendant la période de fonctionnement du moteur électrique 16, et, en particulier, après la première étape de fin 230 de la phase d'initialisation P1.

Le procédé comprend, en outre, au cours de la phase de mesure P2, une deuxième étape de mesure 300, dite « de mesure en fonctionnement initiale », qui consiste à mesurer la tension V_{bat} délivrée par la batterie 24, en particulier au moyen du dispositif de mesure 33. Cette mesure est dite « en charge », car elle s'effectue lorsque la batterie 24 fournit de l'énergie électrique au moteur électrique 16.

Le procédé comprend, en outre, au cours de la phase de mesure P2, une deuxième étape d'enregistrement 310, dite « d'enregistrement en fonctionnement initiale », mise en oeuvre suite à la deuxième étape de mesure 300, qui consiste à enregistrer une valeur de la tension V_{bat} mesurée, lors de la deuxième étape de mesure 300, comme étant une valeur minimale, notée Vₘᵢₙ, de la tension V_{bat}.

Avantageusement, au cours de la phase de mesure P2, le procédé comprend ensuite une boucle mise en oeuvre en continu tout au long de la période de fonctionnement du moteur électrique 16, qui comprend les étapes suivantes, exécutées dans l'ordre mentionné :
- une première étape de temporisation 320, dite « de temporisation en fonctionnement », qui consiste à mettre en oeuvre une pause dans l'exécution du procédé, la durée de cette pause étant égale à une période de temps prédéterminée T1, pouvant être, par exemple, égale à cent millisecondes,
- une troisième étape de mesure 330, dite « de mesure en fonctionnement itérative », qui consiste à mesurer la tension V_{bat} délivrée par la batterie 24, en particulier au moyen du dispositif de mesure 33,
- une première étape de comparaison 340, dite « de comparaison en fonctionnement », qui consiste à comparer une valeur de la tension V_{bat} mesurée avec la valeur minimale Vₘᵢₙ de la tension V_{bat} enregistrée préalablement, lors de la deuxième étape d'enregistrement 310,
- une troisième étape d'enregistrement 350, dite « d'enregistrement en fonctionnement itérative », exécutée uniquement si le résultat de la première étape de comparaison 340 est que la valeur de la tension V_{bat} mesurée, lors de la troisième étape de mesure 330, est strictement inférieure à la valeur minimale Vₘᵢₙ de la tension V_{bat}, qui consiste à rendre égale la valeur minimale Vₘᵢₙ de la tension V_{bat} à la valeur de la tension V_{bat} mesurée, lors de la troisième étape de mesure 330, et
- une étape de vérification 360, qui consiste à vérifier si le moteur électrique 16 est en fonctionnement ou si le déplacement de l'écran 2 au moyen de l'actionneur électromécanique 11 est terminé.

À l'issu de l'étape de vérification 360, si le résultat déterminé est que le moteur électrique 16 est toujours en fonctionnement, c'est-à-dire si le déplacement de l'écran 2 au moyen de l'actionneur électromécanique 11 n'est pas terminé, alors les étapes notées de 320 à 360 sont de nouveau exécutées et le procédé reprend à la première étape de temporisation 320.

Dans le cas contraire, à l'issu de l'étape de vérification 360, si le résultat déterminé est que le moteur électrique 16 n'est plus en fonctionnement, c'est-à-dire si le déplacement de l'écran 2 au moyen de l'actionneur électromécanique 11 est terminé, alors la phase de mesure P2 est terminée et le procédé exécute une phase d'analyse P3.

On comprend que la phase de mesure P2 permet d'enregistrer la valeur minimale Vₘᵢₙ de la tension V_{bat} délivrée par la batterie 24, en particulier au moteur électrique 16, au cours de la période de fonctionnement du moteur électrique 16. En pratique, cette valeur minimale Vₘᵢₙ de la tension V_{bat} est mesurée à l'instant où la puissance électrique délivrée par l'actionneur électromécanique 11 pour déplacer l'écran 2 est maximale, c'est-à-dire lorsque la résistance au déplacement de l'écran 2 est maximale.

Les deuxième et troisième étapes de mesure 300, 330 forment ensemble des étapes de mesure dites « de mesure en fonctionnement ».

Les deuxième et troisième étapes d'enregistrement 310, 350 forment ensemble des étapes d'enregistrement dites « d'enregistrement en fonctionnement ».

L'ordre des étapes notées 300 à 360 de la phase de mesure P2 est donné ici à titre d'exemple et des variations de cet ordre sont envisageables sans avoir d'impact sur l'objectif de la phase de mesure P2, qui est d'enregistrer la valeur minimale Vₘᵢₙ de la tension V_{bat} délivrée par la batterie 24 au cours de la période de fonctionnement du moteur électrique 16.

Par exemple, la première étape de temporisation 320 peut être réalisée juste avant l'étape de vérification 360, c'est-à-dire à la fin de la boucle de la phase de mesure P2.

Selon un autre exemple, la deuxième étape d'enregistrement 310 peut être réalisée au cours de la phase d'initialisation P1, et la valeur minimale Vₘᵢₙ de la tension V_{bat} est alors définie de manière arbitraire comme étant égale à une valeur seuil prédéterminée, dite « élevée », de sorte que la mesure de la tension V_{bat} mise en oeuvre à la troisième étape de mesure 330 indique nécessairement une valeur de la tension V_{bat} strictement inférieure à la valeur minimale Vₘᵢₙ de la tension V_{bat}. Dans cet exemple, la deuxième étape de mesure 300 n'est plus nécessaire et la phase de mesure P2 débute à partir de la troisième étape de mesure 330.

Le procédé comprend, en outre, au cours de la phase d'analyse P3, une étape d'établissement 400, qui consiste à établir l'indicateur SOF, sur la base de la valeur minimale Vₘᵢₙ de la tension V_{bat} enregistrée, autrement dit déterminée, au cours de la phase de mesure P2.

Cette étape d'établissement 400 peut être mise en oeuvre selon plusieurs modes de réalisation.

Dans un premier mode de réalisation de l'étape d'établissement 400, référencé 410 à la figure 5, le procédé comprend, en outre, au cours de la phase d'analyse P3, une deuxième étape de comparaison 412, dite « comparaison de tension », de la valeur minimale Vₘᵢₙ de la tension V_{bat} à une valeur seuil de tension prédéterminée V, dite « minimale », pouvant être, par exemple égale à 8,6V.

Le procédé comprend, en outre, au cours de la phase d'analyse P3, si la valeur minimale Vₘᵢₙ de la tension V_{bat} est strictement inférieure à la valeur seuil de tension prédéterminée V, une première étape d'affectation 414, où l'indicateur SOF est affecté comme étant égal à un état d'indication critique, noté SC.

Dans le cas contraire, le procédé comprend, en outre, au cours de la phase d'analyse P3, si la valeur minimale Vₘᵢₙ de la tension V_{bat} est supérieure ou égale à la valeur seuil de tension prédéterminée V, une deuxième étape d'affectation 416, où l'indicateur SOF est affecté comme étant différent de l'état d'indication critique SC.

On comprend alors que, dans le premier mode de réalisation, l'indicateur SOF peut prendre deux états distincts.

Dans ce premier mode de réalisation, la source d'éclairage 39 du dispositif d'affichage 38 est configurée pour afficher deux couleurs, pouvant être, par exemple, vert et rouge.

En pratique, la valeur seuil de tension prédéterminée V est établie en fonction de caractéristiques spécifiques du dispositif d'occultation 3 et, plus particulièrement, en fonction de performances de l'actionneur électromécanique 11, notamment sa puissance maximale et son rendement, de caractéristiques de l'écran 2, notamment sa masse et ses dimensions, et/ou de caractéristiques de l'installation domotique 100, notamment le coefficient de frottement entre l'écran 2 et les coulisses latérales 6.

Ainsi, pour chaque dispositif d'occultation 3, on définit une valeur seuil de tension prédéterminée V spécifique.

La valeur seuil de tension prédéterminée V peut également prendre en compte un couple maximum délivré par l'actionneur électromécanique 11, au cours du déplacement de l'écran 2.

Avantageusement, l'état d'indication critique SC est prévu comme étant une valeur de la tension V_{bat} en dessous de laquelle la batterie 24 ne dispose plus de capacité suffisante pour réaliser un déplacement de l'écran 2, en particulier un déplacement de montée complet de l'écran 2.

En d'autres termes, l'état d'indication critique SC est défini comme étant le seuil en dessous duquel l'autonomie de la batterie 24 est nulle.

Ainsi, l'indicateur SOF est considéré comme étant égal à l'état d'indication critique SC lorsque l'actionneur électromécanique 11 n'est plus en mesure de procéder à un déplacement de l'écran 2, en particulier un déplacement de montée complet de l'écran 2.

L'indicateur SOF défini à partir de la valeur Vₘᵢₙ de la tension V_{bat} et comparé à l'état d'indication critique SC est particulièrement avantageux, car la valeur Vₘᵢₙ de la tension V_{bat} rend compte des capacités réelles de la batterie 24 à alimenter en énergie électrique le moteur électrique 16, sans déterminer explicitement le niveau de charge de la batterie 24 et le vieillissement de celle-ci.

Ainsi, l'indicateur SOF n'est pas affecté par l'état de la batterie 24, ce qui le rend particulièrement fiable et précis.

Le procédé comprend, en outre, au cours de la phase d'analyse P3, si l'indicateur SOF est égal à l'état d'indication critique SC, une routine 500, mise en oeuvre après la période de fonctionnement du moteur électrique 16, en particulier après l'étape d'établissement 400. La routine 500 a pour but d'interdire le fonctionnement du moteur électrique 16, autrement dit tout mouvement de l'écran 2, tant que l'indicateur SOF est égal à l'état d'indication critique SC, et de n'autoriser le fonctionnement du moteur électrique 16, autrement dit un mouvement de l'écran 2, qu'une fois que l'indicateur SOF est différent de l'état d'indication critique SC, c'est-à-dire une fois que l'autonomie de la batterie 24 est suffisante, ou à nouveau suffisante, pour permettre un déplacement de l'écran 2, en particulier un déplacement de montée complet de l'écran 2.

Le procédé comprend, en outre, au cours de la routine 500, les étapes suivantes :
- une étape d'analyse 510, qui consiste à analyser l'indicateur SOF, en vérifiant si l'indicateur SOF est égal ou différent de l'état d'indication critique SC. Si le résultat de l'étape d'analyse 510 est que l'indicateur SOF est différent de l'état d'indication critique SC, alors le procédé met fin à la routine 500 et met en oeuvre une deuxième étape de fin 560, décrite ci-après. Si le résultat de l'étape d'analyse 510 est que l'indicateur SOF est égal à l'état d'indication critique SC, alors le procédé poursuit la routine 500, en particulier avec une quatrième étape de mesure 520, dite « de mesure ultérieure ».
- la quatrième étape de mesure 520 consiste à mesurer la tension V_{bat} délivrée par la batterie 24, en particulier au moyen du dispositif de mesure 33. Cette mesure est dite « à vide », car elle s'effectue lorsque la batterie 24 ne fournit pas d'énergie électrique au moteur électrique 16.
- une troisième étape de comparaison 530, dite « de comparaison ultérieure », qui consiste à comparer une valeur de la tension V_{bat} mesurée, lors de la quatrième étape de mesure 520, avec une somme de la valeur de référence V_{ref} de la tension V_{bat} et d'un premier facteur de correction prédéterminé ΔV, décrit ci-après. Si le résultat de la troisième étape de comparaison 530 est que la valeur de la tension V_{bat} mesurée, lors de la quatrième étape de mesure 520, est supérieure ou égale à la somme de la valeur de référence V_{ref} de la tension V_{bat} et du premier facteur de correction prédéterminé ΔV, alors le procédé met en œuvre une première étape de modification 550. Dans le cas contraire, si le résultat de la troisième étape de comparaison 530 est que la valeur de la tension V_{bat} mesurée, lors de la quatrième étape de mesure 520, est strictement inférieure à la somme de la valeur de référence V_{ref} de la tension V_{bat} et du premier facteur de correction prédéterminé ΔV, alors le procédé met en œuvre une deuxième étape de temporisation 540, dite « de temporisation ultérieure ».
- la deuxième étape de temporisation 540, qui consiste à mettre en œuvre une pause dans l'exécution du procédé, la durée de cette pause étant égale à une période de temps prédéterminée T2, pouvant être, par exemple, égale à une minute. À l'issu de la deuxième étape de temporisation 540, les étapes de quatrième mesure 520 et de troisième comparaison 530 sont de nouveau exécutées. Ainsi, les étapes notées 520 à 540 forment une boucle que le procédé répète, jusqu'à ce que la tension V_{bat} soit supérieure ou égale à la somme de la valeur de référence V_{ref} de la tension V_{bat} et du premier facteur de correction prédéterminé ΔV, où le procédé met en œuvre la première étape de modification 550.
- la première étape de modification 550 de l'indicateur SOF consiste à modifier l'indicateur SOF, de sorte à le rendre différent de l'état d'indication critique SC. À la suite de la première étape de modification 550, le procédé met en œuvre la deuxième étape de fin 560 de la routine 500.

Le premier facteur de correction prédéterminé ΔV utilisé lors de la troisième étape de comparaison 530 est en pratique un facteur de sécurité, qui est une valeur de tension prédéterminée, en particulier constante, pour le dispositif d'entraînement motorisé 5, et qui est positive ou nulle.

Dans un exemple où le premier facteur de correction prédéterminé ΔV est égal à 0V, la deuxième étape de temporisation 540 consiste à vérifier si la valeur de la tension V_{bat} mesurée, lors de la quatrième étape de mesure 520, est supérieure ou égale à la valeur de référence V_{ref} de la tension V_{bat}.

Selon un autre exemple, le premier facteur de correction prédéterminé ΔV est égal à cent millivolts.

La deuxième étape de fin 560 correspond à la fin de la phase d'analyse P3 et à la fin du procédé.

À l'issue du procédé, le dispositif d'entraînement motorisé 5 est en mesure de déplacer à nouveau l'écran 2, et donc d'exécuter à nouveau les phases notées P1 à P3.

Dans le cas contraire, tant que la phase d'analyse P3 n'est pas terminée, alors l'unité électronique de contrôle 15 interdit la mise en fonctionnement du moteur électrique 16, et donc le déplacement de l'écran 2 au moyen de l'actionneur électromécanique 11, même si un ordre de commande visant à entraîner un déplacement de l'écran 2 est reçu par l'unité électronique de contrôle 15, en particulier par le premier module de communication 27.

En d'autres termes, grâce à la routine 500, la mise en fonctionnement du moteur électrique 16 est impossible tant que l'indicateur SOF est égal à l'état d'indication critique SC. Ceci permet d'éviter un déplacement de l'écran 2 lorsque l'autonomie de la batterie 24 n'est pas suffisante pour effectuer un déplacement de l'écran 2 au moyen de l'actionneur électromécanique 11 et également d'éviter une décharge profonde de la batterie 24, qui serait dommageable pour ses performances et sa longévité.

On comprend que, une fois déterminé que l'indicateur SOF est égal à l'état d'indication critique SC à l'étape d'analyse 510, une recharge de la batterie 24 est nécessaire, l'autonomie de la batterie 24 étant insuffisante pour permettre un déplacement de l'écran 2 au moyen de l'actionneur électromécanique 11. Cette recharge s'effectue, par exemple, au moyen du panneau photovoltaïque 25, d'une batterie auxiliaire ou d'un chargeur. La routine 500 permet alors de surveiller l'avancement de la recharge de la batterie 24 et de n'autoriser à nouveau un déplacement de l'écran 2 au moyen de l'actionneur électromécanique 11, qu'une fois que la recharge de la batterie 24 est suffisamment avancée pour garantir une autonomie suffisante pour permettre un déplacement de l'écran 2.

Il est ainsi particulièrement avantageux que la tension V_{bat} délivrée par la batterie 24 soit comparée à la valeur de référence V_{ref} de la tension V_{bat}, puisque la valeur de référence V_{ref} de la tension V_{bat} a été mesurée au cours de la phase d'initialisation P1, c'est-à-dire avant le déplacement de l'écran 2 au moyen de l'actionneur électromécanique 11 effectué au cours de la phase d'analyse P2.

En d'autres termes, il a été déterminé par la Demanderesse que lorsque la tension V_{bat} dite « à vide » de la batterie 24 est au moins égale à la valeur de référence V_{ref} de la tension V_{bat}, alors la batterie 24 dispose d'une autonomie suffisante pour permettre au moins un déplacement de l'écran 2 au moyen de l'actionneur électromécanique 11.

Par ailleurs, lorsque le premier facteur de correction prédéterminé ΔV est strictement supérieur à 0V, alors un nouveau déplacement de l'écran 2 au moyen de l'actionneur électromécanique 11 n'est autorisé que lorsque l'autonomie de la batterie 24 est supérieure à ce qu'elle était avant le déplacement de l'écran 2 ayant entraîné son basculement dans l'état d'indication critique SC, représenté par l'indicateur SOF.

Le premier facteur de correction prédéterminé ΔV permet ainsi d'éviter que l'indicateur SOF oscille entre l'état d'indication critique SC et l'un des autres états d'indication ou l'autre état d'indication.

Avantageusement, le procédé comprend, en outre, au cours de la phase d'analyse P3, une première étape d'affichage 480, dite « d'affichage préalable », mise en œuvre après l'étape d'établissement 400 et avant la routine 500, qui consiste à afficher sur le dispositif d'affichage 38 l'indicateur SOF.

Dans l'exemple, la première étape d'affichage 480 conduit la source d'éclairage 39 du dispositif d'affichage 38 à afficher une couleur verte si l'indicateur SOF est différent de l'état d'indication critique SC et, dans le cas contraire, à afficher une couleur rouge si l'indicateur SOF est égal à l'état d'indication critique SC.

Avantageusement, le procédé comprend, en outre, au cours de la routine 500 de la phase d'analyse P3, une deuxième étape d'affichage 580, dite « d'affichage ultérieur », mise en œuvre après la première étape de modification 550 de la routine 500 et avant la deuxième étape de fin 560, qui consiste à afficher sur le dispositif d'affichage 38 l'indicateur SOF.

La deuxième étape d'affichage 580 permet de mettre à jour le dispositif d'affichage 38, notamment si l'indicateur SOF égal à l'état d'indication critique SC est établi au cours de l'étape d'établissement 400.

Ainsi, un utilisateur du dispositif d'entraînement motorisé 5 est informé par la deuxième étape d'affichage 580 du basculement de l'indicateur SOF hors de l'état d'indication critique SC et donc de l'instant où un déplacement de l'écran 2 au moyen de l'actionneur électromécanique 11 est à nouveau autorisé par l'unité électronique de contrôle 15.

En pratique, si au cours de l'étape d'analyse 510, le procédé a déterminé que l'indicateur SOF est différent de l'état d'indication critique SC, alors la deuxième étape d'affichage 580 ne modifie pas l'affichage du dispositif d'affichage 38. Dans ce cas de figure, la deuxième étape d'affichage 580 est donc optionnelle.

En pratique, lorsque la batterie 24 est alimentée en énergie électrique par le panneau photovoltaïque 25, alors la tension V_{bat} dite « à vide » mesurée par le dispositif de mesure 33 au cours des première et quatrième étapes de mesure 210, 520 est affectée par le courant électrique délivré par le panneau photovoltaïque 25.

Pour tenir compte du panneau photovoltaïque 25, le procédé comprend, en outre, deux étapes de modification supplémentaires, mises en oeuvre après la première étape de mesure 210 de la phase d'initialisation P1 et après la quatrième étape de mesure 520 de la phase d'analyse P3, notées respectivement 240 et 570.

Au cours de la deuxième étape de modification 240, dite « de modification préalable », la valeur de référence V_{ref} de la tension V_{bat}, enregistrée, lors de la première étape d'enregistrement 220, et correspondant à la valeur de la tension V_{bat} mesurée, lors de la première étape de mesure 210 de la phase d'initialisation P1, est modifiée avec un deuxième facteur de correction ΔC1, en particulier est diminuée du deuxième facteur de correction ΔC1.

De même, au cours de la troisième étape de modification 570, dite « de modification ultérieure », la valeur de la tension V_{bat} mesurée, lors de la quatrième étape de mesure 520 de la phase d'analyse P3, est modifiée avec un troisième facteur de correction ΔC2, en particulier est diminuée du troisième facteur de correction ΔC2.

Avantageusement, le deuxième facteur de correction ΔC1 est fonction de l'intensité Iₚᵥ du courant électrique mesurée au niveau du panneau photovoltaïque 25, au moment de la première étape de mesure 210 de la tension V_{bat} délivrée par la batterie 24 au cours de la phase d'initialisation P1.

En pratique, le deuxième facteur de correction ΔC1 est égal au produit d'une résistance interne Rᵢₙₜ de la batterie 24 avec l'intensité Iₚᵥ du courant électrique délivré par le panneau photovoltaïque 25 et mesurée par le dispositif de mesure 33. La mesure de l'intensité Iₚᵥ du courant électrique délivré par le panneau photovoltaïque 25 est mise en oeuvre au cours de la phase d'initialisation P1, simultanément à la première étape de mesure 210 pour mesurer la tension V_{bat} de la batterie 24.

La résistance interne Rᵢₙₜ de la batterie 24 a tendance à augmenter pendant le déplacement de l'écran 2 mis en oeuvre au moyen de l'actionneur électromécanique 11, en particulier au cours du déplacement de montée de l'écran 2. La valeur minimale Vₘᵢₙ de la tension V_{bat} peut être atteinte au bout de quelques secondes alors que le pic de puissance fourni par l'actionneur électromécanique 11 a été passé. En effet, la chute de tension maximale, qui amène à la valeur minimale Vₘᵢₙ de la tension V_{bat}, est le produit de la résistance interne Rᵢₙₜ de la batterie 24 par l'intensité Iₚᵥ du courant électrique délivré par le panneau photovoltaïque 25.

Avantageusement, le troisième facteur de correction ΔC2 est fonction de l'intensité Iₚᵥ du courant électrique mesurée au niveau du panneau photovoltaïque 25, au moment de la quatrième étape de mesure 520 de la tension V_{bat} délivrée par la batterie 24 au cours de la routine 500.

En pratique, le troisième facteur de correction ΔC2 est égal au produit de la résistance interne Rᵢₙₜ de la batterie 24 avec l'intensité Iₚᵥ du courant électrique délivré par le panneau photovoltaïque 25 et mesurée par le dispositif de mesure 33. La mesure de l'intensité Iₚᵥ du courant électrique délivré par le panneau photovoltaïque 25 est mise en œuvre au cours de la routine 500 de la phase d'analyse P3, simultanément à la quatrième étape de mesure 520 pour mesurer la tension V_{bat} de la batterie 24.

En pratique, la résistance interne Rᵢₙₜ de la batterie 24 étant variable, cette résistance interne Rᵢₙₜ est soit mesurée au cours d'étapes supplémentaires du procédé mises en œuvre avant les deuxième et troisième étapes de modification 240, 570, non décrites ici en détail, soit approximée par une valeur constante, de préférence représentative d'un cas le plus défavorable, c'est-à-dire d'une résistance interne Rᵢₙₜ maximale.

Les deuxième et troisième étapes de modification 240, 570 permettent donc de tenir compte de l'impact du panneau photovoltaïque 25 sur la mesure de la tension V_{bat} dite « à vide ». Ceci est particulièrement avantageux pour obtenir une estimation fiable de l'autonomie de la batterie 24.

En variante, non représentée, le dispositif d'entraînement motorisé 5, en particulier l'unité électronique de contrôle 15, comprend un ou plusieurs éléments, non représentés, configurés pour isoler électriquement, autrement dit isolant électriquement, la batterie 24 du panneau photovoltaïque 25, lors des étapes de mesure de la tension V_{bat}, pouvant être, par exemple, un interrupteur ou un transistor. Dans ce cas-là, la mesure de la tension V_{bat} est réellement mise en œuvre à vide. Dans une telle variante, les deuxième et troisième étapes de modification 240, 570 ne sont alors pas mises en œuvre, le panneau photovoltaïque 25 n'ayant pas d'impact sur la mesure de la tension V_{bat}.

On décrit à présent un deuxième mode de réalisation de l'étape d'établissement 400, référencé 430 à la figure 5.

Dans ce deuxième mode de réalisation de l'étape d'établissement 400, l'indicateur SOF est prévu pour pouvoir prendre quatre états distincts :
- un premier état, dans lequel l'indicateur SOF est égal à l'état d'indication critique SC,
- un deuxième état, dans lequel l'indicateur SOF est égal à un premier état d'indication de référence S1,
- un troisième état, dans lequel l'indicateur SOF est égal à un deuxième état d'indication de référence S2, et
- un quatrième état, dans lequel l'indicateur SOF est égal à un troisième état d'indication de référence S3.

Avantageusement, dans le deuxième mode de réalisation de l'étape d'établissement 400, la source d'éclairage 39 du dispositif d'affichage 38 est configurée pour afficher quatre couleurs.

Par exemple, l'état d'indication critique SC est associé à la couleur rouge, le premier état d'indication de référence S1 est associé à la couleur orange, le deuxième état d'indication de référence S2 est associé à la couleur jaune et le troisième état d'indication de référence S3 est associé à la couleur verte.

Dans le deuxième mode de réalisation de l'étape d'établissement 400, le procédé comprend, en outre, au cours de la phase d'analyse P3, trois étapes de comparaison 432, 436, 440 de la valeur minimale Vₘᵢₙ de la tension V_{bat} à trois valeurs seuils de tension prédéterminées V1, V2, V3 distinctes, pouvant être, par exemple, respectivement égales à 8,6V, à 9V et à 9,5V.

Au cours de la quatrième étape de comparaison 432, la valeur minimale Vₘᵢₙ de la tension V_{bat} est comparée à la troisième valeur seuil de tension prédéterminée V3.

Le procédé comprend, en outre, au cours de la phase d'analyse P3, si la valeur minimale Vₘᵢₙ de la tension V_{bat} est supérieure ou égale à la troisième valeur seuil de tension prédéterminée V3, une troisième étape d'affectation 434, où l'indicateur SOF est affecté comme étant égal au troisième état d'indication de référence S3.

Dans le cas contraire, au cours de la cinquième étape de comparaison 436, la valeur minimale Vₘᵢₙ de la tension V_{bat} est comparée à la deuxième valeur seuil de tension prédéterminée V2.

Le procédé comprend, en outre, au cours de la phase d'analyse P3, si la valeur minimale Vₘᵢₙ de la tension V_{bat} est supérieure ou égale à la deuxième valeur seuil de tension prédéterminée V2 et strictement inférieure à la troisième valeur seuil de tension prédéterminée V3, une quatrième étape d'affectation 438, où l'indicateur SOF est affecté comme étant égal au deuxième état d'indication de référence S2.

Dans le cas contraire, au cours de la sixième étape de comparaison 440, la valeur minimale Vₘᵢₙ de la tension V_{bat} est comparée à la première valeur seuil de tension prédéterminée V1, dite « minimale ».

Le procédé comprend, en outre, au cours de la phase d'analyse P3, si la valeur minimale Vₘᵢₙ de la tension V_{bat} est supérieure ou égale à la première valeur seuil de tension prédéterminée V1 et strictement inférieure à la deuxième valeur seuil de tension prédéterminée V2, une cinquième étape d'affectation 442, où l'indicateur SOF est affecté comme étant égal au premier état d'indication de référence S1.

Dans le cas contraire, le procédé comprend, en outre, au cours de la phase d'analyse P3, si la valeur minimale Vₘᵢₙ de la tension V_{bat} est strictement inférieure à la première valeur seuil de tension prédéterminée V1, une sixième étape d'affectation 444, où l'indicateur SOF est affecté comme égal à l'état d'indication critique SC.

Le deuxième mode de réalisation de l'étape d'établissement 400 est avantageux pour estimer avec plus de finesse l'autonomie disponible de la batterie 24, car il est alors possible de représenter cette autonomie avec un plus grand nombre d'états, dans l'exemple quatre états. L'utilisateur du dispositif d'entraînement motorisé 5 peut alors être informé avec plus de précision du nombre de cycles de déplacement de l'écran 2 que la batterie 24 est en mesure de mettre en oeuvre, et peut donc, par exemple, estimer avec plus de précision la nécessité de procéder à une recharge de la batterie 24.

On comprend que l'étape d'établissement 400 selon le deuxième mode de réalisation est facilement généralisable à un nombre d'états de l'indicateur SOF différent de quatre, pouvant être, par exemple, de trois ou de cinq états, permettant de choisir le degré de précision souhaité dans l'estimation de l'autonomie de la batterie 24.

On décrit à présent un troisième mode de réalisation de l'étape d'établissement 400, référencé 450 à la figure 5.

Dans ce troisième mode de réalisation de l'étape d'établissement 400, l'indicateur SOF est prévu pour pouvoir prendre quatre états distincts SC, S4, S5, S6, associés chacun à une couleur de la source d'éclairage 39 du dispositif d'affichage 38, comme dans le deuxième mode de réalisation.

Le troisième mode de réalisation de l'étape d'établissement 400 est en pratique mis en oeuvre lorsque le dispositif d'entraînement motorisé 5 comprend une fonction de limitation de puissance consommée par l'actionneur électromécanique 11, qui consiste à ralentir la vitesse de rotation R du moteur électrique 16 si la puissance délivrée par la batterie 24 devient trop importante, afin de protéger la batterie 24.

Une telle fonction influence la tension V_{bat} délivrée par la batterie 24 pendant la période de fonctionnement du moteur électrique 16 et, par conséquent, pendant le déplacement de l'écran 2 au moyen de l'actionneur électromécanique 11.

Ainsi, lorsqu'une telle fonction est mise en œuvre, la tension V_{bat} délivrée par la batterie 24 peut ne pas descendre sous une valeur seuil critique de tension prédéterminée V_{crit}, qui correspondrait, dans l'exemple des premier et deuxième modes de réalisation, au passage à l'état d'indication critique SC, même lorsque l'autonomie de la batterie 24 est critique.

Pour tenir compte d'une telle fonction, l'étape d'établissement 400 de l'indicateur SOF est mise en œuvre en tenant également compte de la vitesse de rotation R du moteur électrique 16 et, par conséquent de l'arbre de sortie 20 de l'actionneur électromécanique 11 et du tube d'enroulement 4 et, plus particulièrement, de la valeur maximale Rₘₐₓ de la vitesse de rotation R atteinte par le moteur électrique 16 et, par conséquent de l'arbre de sortie 20 de l'actionneur électromécanique 11 et du tube d'enroulement 4, au cours d'un déplacement de l'écran 2 au moyen de l'actionneur électromécanique 11, en particulier d'un déplacement complet de l'écran 2.

Avantageusement, afin de mettre en œuvre le troisième mode de réalisation de l'étape d'établissement 400, le procédé comprend, en outre, au cours de la phase d'initialisation P1, une étape supplémentaire d'initialisation 250, dite « d'initialisation de vitesse », qui consiste à initialiser une valeur maximale Rₘₐₓ de la vitesse de rotation R comme étant égale à une valeur prédéterminée, pouvant être, par exemple, égale à 0 tour par minute. L'étape d'initialisation 250 est réalisée entre l'étape de démarrage 200 et la première étape de fin 230 de la phase d'initialisation P1, par exemple en parallèle des étapes de première mesure 210, de premier enregistrement 220 et de deuxième modification 240 de la phase d'initialisation P1.

Avantageusement, le procédé comprend, en outre, au cours de la phase de mesure P2, trois étapes supplémentaires 370, 380, 390, mises en œuvre dans la boucle de la phase de mesure P2, tout au long de la période de fonctionnement du moteur électrique 16, qui sont les suivantes :
- une cinquième étape de mesure 370, dite « mesure de vitesse », qui consiste à mesurer la vitesse de rotation R du moteur électrique 16,
- une septième étape de comparaison 380, dite « comparaison de vitesse », qui consiste à comparer la vitesse de rotation R mesurée, lors de la cinquième étape de mesure 370, avec la valeur maximale Rₘₐₓ de la vitesse de rotation R, et
- une quatrième étape d'enregistrement 390, dite « d'enregistrement de vitesse », exécutée uniquement si le résultat de la septième étape de comparaison 380 est que la vitesse de rotation R mesurée, lors de la cinquième étape de mesure 370, est strictement supérieure à la valeur maximale Rₘₐₓ de la vitesse de rotation R, qui consiste à rendre égale la valeur maximale Rₘₐₓ de la vitesse de rotation R à la valeur de la vitesse de rotation R mesurée, lors de la cinquième étape de mesure 370.

Ici et comme illustré à la figure 4, les étapes 370, 380, 390 de la phase de mesure P2 sont exécutées entre la première étape de temporisation 320 et l'étape de vérification 360.

Par exemple, la cinquième étape de mesure 370 est mise en oeuvre après la troisième étape de mesure 330. En outre, la septième étape de comparaison 380 et la quatrième étape d'enregistrement 390 sont mises en oeuvre en parallèle de la première étape de comparaison 340 et de la troisième étape d'enregistrement 350.

Dans le troisième mode de réalisation de l'étape d'établissement 400, le procédé comprend, en outre, au cours de la phase d'analyse P3, une huitième et une neuvième étapes de comparaison 452, 456 de la valeur minimale Vₘᵢₙ de la tension V_{bat} à deux valeurs seuils de tension prédéterminées V4, V5, pouvant être, par exemple respectivement égales à 9V et à 9,5V, et une dixième étape de comparaison 460 de la valeur maximale Rₘₐₓ de la vitesse de rotation R à une valeur seuil de vitesse prédéterminée R1, pouvant être, par exemple, égale à 4 tours par minute.

Au cours de la huitième étape de comparaison 452, la valeur minimale Vₘᵢₙ de la tension V_{bat} est comparée à la cinquième valeur seuil de tension prédéterminée V5.

Le procédé comprend, en outre, au cours de la phase d'analyse P3, si la valeur minimale Vₘᵢₙ de la tension V_{bat} est supérieure ou égale à la cinquième valeur seuil de tension prédéterminée V5, une septième étape d'affectation 454, où l'indicateur SOF est affecté comme étant égal au sixième état d'indication de référence S6.

Dans le cas contraire, au cours de la neuvième étape de comparaison 456, la valeur minimale Vₘᵢₙ de la tension V_{bat} est comparée à la quatrième valeur seuil de tension prédéterminée V4, dite « minimale ».

Le procédé comprend, en outre, au cours de la phase d'analyse P3, si la valeur minimale Vₘᵢₙ de la tension V_{bat} est supérieure ou égale à la quatrième valeur seuil de tension prédéterminée V4 et strictement inférieure à la cinquième valeur seuil de tension prédéterminée V5, une huitième étape d'affectation 458, où l'indicateur SOF est affecté comme étant égal au cinquième état d'indication de référence S5.

Dans le cas contraire, au cours de la dixième étape de comparaison 460, la valeur maximale Rₘₐₓ de la vitesse de rotation R est comparée à la valeur seuil de vitesse prédéterminée R1.

Le procédé comprend, en outre, au cours de la phase d'analyse P3, si la valeur maximale Rₘₐₓ de la vitesse de rotation R est supérieure ou égale à la valeur seuil de vitesse prédéterminée R1 et si la valeur minimale Vₘᵢₙ de la tension V_{bat} est strictement inférieure à la quatrième valeur seuil de tension prédéterminée V4, une neuvième étape d'affectation 462, où l'indicateur SOF est affecté comme étant égal au quatrième état d'indication de référence S4.

Dans le cas contraire, le procédé comprend, en outre, au cours de la phase d'analyse P3, si la valeur maximale Rₘₐₓ de la vitesse de rotation R est strictement inférieure à la valeur seuil de vitesse prédéterminée R et si la valeur minimale Vₘᵢₙ de la tension V_{bat} est strictement inférieure à la quatrième valeur seuil de tension prédéterminée V4, une dixième étape d'affectation 464, où l'indicateur SOF est affecté comme égal à l'état d'indication critique SC.

Le troisième mode de réalisation de l'étape d'établissement 400 est avantageux pour tenir compte de la présence d'une fonction de limitation de puissance consommée par l'actionneur électromécanique 11, en se basant à la fois sur la valeur minimale Vₘᵢₙ de la tension V_{bat} mesurée, lors de la troisième étape de mesure 330, et sur la valeur maximale Rₘₐₓ de la vitesse de rotation R du moteur électrique 16 mesurée, lors de la cinquième étape de mesure 370.

L'autonomie de la batterie 24 est ainsi estimée avec précision, malgré la présence de la fonction de limitation de puissance consommée par l'actionneur électromécanique 11 qui influe sur la tension V_{bat} dite « à vide » mesurée.

En variante du troisième mode de réalisation, la vitesse de rotation R du moteur électrique 16 est directement mesurée, en particulier au moyen du dispositif de comptage.

Comme pour le deuxième mode de réalisation de l'étape d'établissement 400, on comprend que l'étape d'établissement 400 selon le troisième mode de réalisation est facilement généralisable à un nombre d'états de l'indicateur SOF différent de quatre, pouvant être, par exemple, de trois ou de cinq états. Quel que soit le nombre d'états choisi, la dixième étape de comparaison 460 avec la valeur maximale Rₘₐₓ de la vitesse de rotation R est mise en oeuvre pour déterminer si l'indicateur SOF est égal à l'état d'indication critique SC ou au quatrième état d'indication de référence S4.

La valeur seuil de tension prédéterminée V du premier mode de réalisation 410 de l'étape d'établissement 400, la première valeur seuil de tension prédéterminée V1 du deuxième mode de réalisation 430 et la quatrième valeur seuil de tension prédéterminée V4 du troisième mode de réalisation 450 de l'étape d'établissement 400 peuvent être identiques ou différentes, mais celles-ci correspondent toutes à une valeur seuil de tension prédéterminée minimale pour le mode de réalisation 410, 430, 450 associé.

De nombreuses modifications peuvent être apportées aux exemples de réalisation décrits précédemment, sans sortir du cadre de l'invention défini par les revendications.

En variante, non représentée, l'étape d'établissement 400 de l'indicateur SOF et, éventuellement, la première étape d'affichage 480 sont mises en oeuvre au cours de la boucle de la phase de mesure P2, par exemple au cours de l'étape de fin 360 de la phase de mesure P2. Ainsi, l'indicateur SOF est établi et modifié en temps réel au cours du déplacement de l'écran 2 au moyen de l'actionneur électromécanique 11. Ceci permet de rendre compte de l'évolution de l'autonomie de la batterie 24 au cours du déplacement de l'écran 2.

En variante, non représentée, le dispositif d'alimentation en énergie électrique 26 comprend, en outre, un chargeur. Ce chargeur est configuré pour être branché, autrement dit est branché, sur une prise électrique murale, de sorte à recharger la batterie 24 à partir d'un réseau d'alimentation électrique du secteur. Ce chargeur forme une source d'alimentation en énergie électrique externe.

En variante, non représentée, le dispositif d'alimentation en énergie électrique 26 comprend, en outre, une batterie auxiliaire, la batterie auxiliaire étant configurée pour recharger la batterie 24. Ainsi, la batterie 24 peut être rechargée au moyen de la batterie auxiliaire formant une source d'alimentation en énergie électrique externe, en particulier dans le cas où le dispositif d'occultation 3 est éloigné d'une prise électrique murale. En outre, la batterie auxiliaire peut permettre de recharger une batterie d'autres équipements électriques, notamment nomades, tels que, par exemple, un téléphone portable ou un ordinateur portable. Par ailleurs, une telle batterie auxiliaire, peut présenter au moins deux sorties électriques, en particulier une première sortie délivrant une tension de 12 volts pour alimenter en énergie électrique la batterie 24 et une deuxième sortie délivrant une tension de 5 volts pour alimenter en énergie électrique d'autres équipements électriques, dits nomades.

En variante, non représentée, l'actionneur électromécanique 11 est inséré dans un rail, en particulier de section carrée ou rectangulaire, pouvant être ouvert à l'une ou à ses deux extrémités, en particulier dans la configuration assemblée du dispositif d'occultation 3. Par ailleurs, l'actionneur électromécanique 11 peut être configuré pour entraîner un arbre d'entraînement sur lequel s'enroule des cordons de déplacement et/ou d'orientation de l'écran 2, qui peut, avantageusement, être un store à lames dans ce cas.

En outre, les modes de réalisation et variantes envisagés peuvent être combinés pour générer de nouveaux modes de réalisation de l'invention, sans sortir du cadre de l'invention défini par les revendications.

## Revendications

1. Procédé de commande en fonctionnement d'un dispositif d'entraînement motorisé (5), le dispositif d'entraînement motorisé (5) comprenant au moins :
- un actionneur électromécanique (11),
- une unité électronique de contrôle (15), et
- un dispositif d'alimentation en énergie électrique (26),
l'actionneur électromécanique (11) comprenant au moins un moteur électrique (16), le dispositif d'alimentation en énergie électrique (26) comprenant au moins une batterie (24), l'unité électronique de contrôle (15) et le moteur électrique (16) étant alimentés en énergie électrique à partir de la batterie (24), la batterie (24) délivrant une tension (Vbat),
**caractérisé en ce que** le procédé comprend au moins :
- une phase de mesure (P2), mise en oeuvre pendant une période de fonctionnement du moteur électrique (16), au cours de laquelle, le procédé comprend au moins :
- une étape de mesure en fonctionnement (300, 330) de la tension (V_{bat}) délivrée par la batterie (24), et
- une étape d'enregistrement en fonctionnement (310, 350) d'une valeur minimale (Vₘᵢₙ) de la tension (V_{bat}) délivrée par la batterie (24),
- et une phase d'analyse (P3), au cours de laquelle, le procédé comprend au moins :
- une étape d'établissement (400), sur la base de la valeur minimale (Vₘᵢₙ) de la tension (V_{bat}) enregistrée au cours de la phase de mesure (P2), d'un indicateur (SOF) représentatif de l'autonomie de la batterie (24), et
- après la période de fonctionnement du moteur électrique (16), si l'indicateur (SOF) est égal à un état d'indication critique (SC), une routine (500) interdisant le fonctionnement du moteur électrique (16), la routine (500) étant exécutée tant que l'indicateur (SOF) est égal à l'état d'indication critique (SC),
et **en ce que** le procédé est mis en oeuvre lorsque le dispositif d'entraînement motorisé (5) entraîne en déplacement un écran (2) d'un dispositif d'occultation (3), dans un mouvement de l'écran (2) requérant la plus grande puissance délivrée par l'actionneur électromécanique (11).

2. Procédé de commande en fonctionnement d'un dispositif d'entraînement motorisé (5) selon la revendication 1, **caractérisé en ce que** le mouvement de l'écran (2) requérant la plus grande puissance délivrée par l'actionneur électromécanique (11) est un mouvement de montée de l'écran (2).

3. Procédé de commande en fonctionnement d'un dispositif d'entraînement motorisé (5) selon l'une quelconque des revendications 1 à 2, **caractérisé**
**en ce que** le procédé comprend, en outre, une phase d'initialisation (P1), mise en oeuvre préalablement à la période de fonctionnement du moteur électrique (16), au cours de laquelle, le procédé comprend, en outre :
- une étape de mesure préalable (210) de la tension (V_{bat}) délivrée par la batterie (24), et
- une étape d'enregistrement préalable (220) d'une valeur de la tension (V_{bat}) mesurée comme étant une valeur de référence (V_{ref}),
**en ce que** le procédé comprend, en outre, au cours de la routine (500) interdisant le fonctionnement du moteur électrique (16) et tant que l'indicateur (SOF) est égal à l'état d'indication critique (SC) :
- une étape de mesure ultérieure (520) de la tension (V_{bat}) délivrée par la batterie (24), et
- une étape de comparaison ultérieure (530) d'une valeur de la tension (V_{bat}) mesurée à la valeur de référence (V_{ref}),
**en ce que**, si la valeur de la tension (V_{bat}) mesurée, lors de l'étape de mesure ultérieure (520), est strictement inférieure à une somme de la valeur de référence (V_{ref}) de la tension (V_{bat}) et d'un premier facteur de correction prédéterminé (ΔV), le procédé met en oeuvre, au cours de la routine (500), de nouveau les étapes de mesure ultérieure (520) et de comparaison ultérieure (530), après une étape de temporisation (540),
**en ce que**, si la valeur de la tension (V_{bat}) mesurée, lors de l'étape de mesure ultérieure (520), est supérieure ou égale à la somme de la valeur de référence (V_{ref}) de la tension (V_{bat}) et du premier facteur de correction prédéterminé (ΔV), le procédé comprend, en outre, au cours de la routine (500) :
- une étape de modification (550) de l'indicateur (SOF), de sorte à ce que l'indicateur (SOF) soit différent de l'état d'indication critique (SC), et
- une étape de fin (560) de la routine (500),
et **en ce que** le premier facteur de correction prédéterminé (ΔV) est une valeur de tension prédéterminée supérieure ou égale à zéro.

4. Procédé de commande en fonctionnement d'un dispositif d'entraînement motorisé (5) selon la revendication 3, **caractérisé**
**en ce que** le dispositif d'alimentation en énergie électrique (26) comprend, en outre, un panneau photovoltaïque (25), le panneau photovoltaïque (25) alimentant en énergie électrique la batterie (24),
**en ce que** le procédé comprend, en outre :
- au cours de la phase d'initialisation (P1), une étape de modification préalable (240) de la valeur de référence (V_{ref}) de la tension (V_{bat}) avec un deuxième facteur de correction (ΔC1), le deuxième facteur de correction (ΔC1) étant fonction de l'intensité (Iₚᵥ) du courant électrique mesurée au niveau du panneau photovoltaïque (25), au moment de l'étape de mesure préalable (210) de la tension (V_{bat}) délivrée par la batterie (24) au cours de la phase d'initialisation (P1), et
- au cours de la routine (500), si l'indicateur (SOF) est égal à l'état d'indication critique (SC), une étape de modification ultérieure (570), exécutée entre l'étape de mesure ultérieure (520) et l'étape de comparaison ultérieure (530) de la routine (500), de la valeur de la tension (V_{bat}) mesurée avec un troisième facteur de correction (ΔC2), le troisième facteur de correction (ΔC2) étant fonction de l'intensité (Iₚᵥ) du courant électrique mesurée au niveau du panneau photovoltaïque (25), au moment de l'étape de mesure ultérieure (520) de la tension (V_{bat}) délivrée par la batterie (24) au cours de la routine (500).

5. Procédé de commande en fonctionnement d'un dispositif d'entraînement motorisé (5) selon l'une quelconque des revendications 1 à 4, **caractérisé en ce que**, au cours de l'étape d'établissement (400) de l'indicateur (SOF), l'indicateur (SOF) est défini (410 ; 430) comme étant égal à l'état d'indication critique (SC) si la valeur minimale (Vₘᵢₙ) de la tension (V_{bat}) est strictement inférieure à une valeur seuil de tension prédéterminée minimale (V ; V1).

6. Procédé de commande en fonctionnement d'un dispositif d'entraînement motorisé (5) selon l'une quelconque des revendications 1 à 4, **caractérisé**
**en ce que**, au cours de la phase de mesure (P2), le procédé comprend, en outre :
- une étape de mesure (370) d'une vitesse de rotation (R) du moteur électrique (16), et
- une étape d'enregistrement (390) d'une valeur maximale (Rₘₐₓ) de la vitesse de rotation (R) du moteur électrique (16),
et **en ce que**, au cours de l'étape d'établissement (400) de l'indicateur (SOF), l'indicateur (SOF) est défini (450) comme étant égal à l'état d'indication critique (SC),
si la valeur minimale (Vₘᵢₙ) de la tension (V_{bat}) enregistrée est strictement inférieure à une valeur seuil de tension prédéterminée minimale (V4) et si la valeur maximale (Rₘₐₓ) de la vitesse de rotation (R) enregistrée est strictement inférieure à une valeur seuil de vitesse prédéterminée (R1).

7. Procédé de commande en fonctionnement d'un dispositif d'entraînement motorisé (5) selon l'une quelconque des revendications 1 à 6, **caractérisé en ce que** le procédé, comprend, en outre, au cours de la phase d'analyse (P3), une étape d'affichage (480, 580) de l'indicateur (SOF) sur un dispositif d'affichage (38).

8. Dispositif d'entraînement motorisé (5),
le dispositif d'entraînement motorisé (5) comprenant au moins :
- un actionneur électromécanique (11),
- une unité électronique de contrôle (15), et
- un dispositif d'alimentation en énergie électrique (26),
l'actionneur électromécanique (11) comprenant au moins un moteur électrique (16), le dispositif d'alimentation en énergie électrique (26) comprenant au moins une batterie (24), l'unité électronique de contrôle (15) et le moteur électrique (16) étant alimentés en énergie électrique à partir de la batterie (24), la batterie (24) délivrant une tension (V_{bat}),
**caractérisé en ce que** l'unité électronique de contrôle (15) du dispositif d'entraînement motorisé (5) est configurée pour mettre en œuvre le procédé selon l'une quelconque des revendications 1 à 7.

9. Dispositif d'occultation (3) comprenant au moins :
- un écran (2), et
- un dispositif d'entraînement motorisé (5),
l'écran (2) étant configuré pour être entraîné en déplacement par l'actionneur électromécanique (11) du dispositif d'entraînement motorisé (5), **caractérisé en ce que** le dispositif d'entraînement motorisé (5) est conforme à la revendication 8.

10. Dispositif d'occultation (3) selon la revendication 9, **caractérisé**
**en ce que** le dispositif d'occultation (3) comprend, en outre, un tube d'enroulement (4),
**en ce que** l'écran (2) est enroulable sur le tube d'enroulement (4),
et **en ce que** le tube d'enroulement (4) est agencé de sorte à être entraîné en rotation par l'actionneur électromécanique (11).

## Patentansprüche

1. Betriebssteuerverfahren einer motorisierten Antriebsvorrichtung (5), die motorisierte Antriebsvorrichtung (5) mindestens umfassend:
- einen elektromechanischen Aktuator (11),
- eine elektronische Steuereinheit (15), und
- eine Versorgungsvorrichtung elektrischer Energie (26),
der elektromechanische Aktuator (11) umfassend mindestens einen Elektromotor (16), die Versorgungsvorrichtung elektrischer Energie (26) umfassend mindestens eine Batterie (24), wobei die elektronische Steuereinheit (15) und der Elektromotor (16) von der Batterie (24) mit elektrischer Energie versorgt werden, die Batterie (24) eine Spannung (V_{bat}) liefert,
**dadurch gekennzeichnet, dass** das Verfahren mindestens Folgendes umfasst:
- eine Messphase (P2), die während einer Betriebsperiode des Elektromotors (16) durchgeführt wird, während der das Verfahren mindestens Folgendes umfasst:
- einen Messschritt (300, 330) im Betrieb der Spannung (V_{bat}), die von der Batterie (24) geliefert wird, und
- einen Aufzeichnungsschritt im Betrieb (310, 350) eines Minimalwerts (Vₘᵢₙ) der Spannung (V_{bat}), die von der Batterie (24) geliefert wird,
- und eine Analysephase (P3), während der das Verfahren mindestens Folgendes umfasst:
- einen Erstellungsschritt (400), basierend auf dem Minimalwert (Vₘᵢₙ) der Spannung (V_{bat}), die während der Messphase (P2) aufgezeichnet wird, eines Indikators (SOF), der repräsentativ für die Autonomie der Batterie (24) ist, und
- wenn der Indikator (SOF) nach der Betriebsperiode des Elektromotors (16), gleich wie ein kritischer Anzeigezustand (SC) ist, eine Routine (500), die den Betrieb des Elektromotors (16) verbietet, wobei die Routine (500) ausgeführt wird, solange der Indikator (SOF) gleich wie der kritische Anzeigezustand (SC) ist,
und dass das Verfahren durchgeführt wird, wenn die motorisierte Antriebsvorrichtung (5) einen Schirm (2) einer Abdeckvorrichtung (3) in einer Bewegung des Schirms (2), die die größte von dem elektromechanischen Aktuator (11) gelieferte Leistung erfordert, bewegbar antreibt.

2. Betriebssteuerverfahren einer motorisierten Antriebsvorrichtung (5) nach Anspruch 1, **dadurch gekennzeichnet, dass** die Bewegung des Schirms (2), die die größte von dem elektromechanischen Aktuator (11) gelieferte Leistung erfordert, eine Aufwärtsbewegung des Schirms (2) ist.

3. Betriebssteuerverfahren einer motorisierten Antriebsvorrichtung (5) nach einem der Ansprüche 1 bis 2, **dadurch gekennzeichnet,**
**dass** das Verfahren ferner eine Initialisierungsphase (P1) umfasst, die vor der Betriebsperiode des Elektromotors (16) durchgeführt wird, während der das Verfahren ferner Folgendes umfasst:
- einen vorherigen Messschritt (210) der Spannung (V_{bat}), die von der Batterie (24) geliefert wird, und
- einen vorherigen Aufzeichnungsschritt (220) eines Werts der Spannung (V_{bat}), der als ein Referenzwert (V_{ref}) gemessen wird,
**dass** das Verfahren ferner während der Routine (500), die den Betrieb des Elektromotors (16) verbietet, und solange der Indikator (SOF) gleich wie der kritische Indikatorzustand (SC) ist, Folgendes umfasst:
- einen nachfolgenden Messschritt (520) der Spannung (V_{bat}), die von der Batterie (24) geliefert wird, und
- einen nachfolgenden Vergleichsschritt (530) eines gemessenen Werts der Spannung (V_{bat}) mit dem Referenzwert (V_{ref}),
**dass**, wenn der Wert der Spannung (V_{bat}), der in dem nachfolgenden Messschritt (520) gemessen wird, strikt kleiner ist als eine Summe aus dem Referenzwert (V_{ref}) der Spannung (V_{bat}) und einem ersten vorbestimmten Korrekturfaktor (ΔV), das Verfahren während der Routine (500) nach einem Verzögerungsschritt (540) erneut den nachfolgenden Messschritt (520) und den nachfolgenden Vergleichungsschritt (530) durchführt,
**dass**, wenn der Wert der gemessenen Spannung (V_{bat}) in dem nachfolgenden Messschritt (520) größer als oder gleich wie die Summe aus dem Referenzwert (V_{ref}) der Spannung (V_{bat}) und dem ersten vorbestimmten Korrekturfaktor (ΔV) ist, das Verfahren während der Routine (500) ferner Folgendes umfasst:
- einen Modifizierungschritt (550) des Indikators (SOF), sodass sich der Indikator (SOF) von dem Zustand der kritischen Anzeige (SC) unterscheidet, und
- einen Beendigungsschritt (560) der Routine (500),
und **dass** der erste vorbestimmte Korrekturfaktor (ΔV) ein vorbestimmter Spannungswert größer als oder gleich wie Null ist.

4. Betriebssteuerverfahren einer motorisierten Antriebsvorrichtung (5) nach Anspruch 3,
**dadurch gekennzeichnet,**
**dass** die Versorgungsvorrichtung elektrischer Energie (26) ferner ein Solarmodul (25) umfasst, wobei das Solarmodul (25) die Batterie (24) mit elektrischer Energie versorgt, dass das Verfahren ferner Folgendes umfasst:
- während der Initialisierungsphase (P1) einen vorherigen Modifizierungschritt (240) des Referenzwerts (V_{ref}) der Spannung (V_{bat}) mit einem zweiten Korrekturfaktor (ΔC1), wobei der zweite Korrekturfaktor (ΔC1) abhängig von der Intensität (Iₚᵥ) des elektrischen Stroms ist, die an dem Solarmodul (25) zum Zeitpunkt des vorherigen Messschritt (210) der von der Batterie (24) während der Initialisierungsphase (P1) gelieferten Spannung (V_{bat}) gemessen wird, und
- wenn der Indikator (SOF) während der Routine (500) gleich wie der kritische Anzeigezustand (SC) ist, einen nachfolgenden Änderungsschritt (570), der zwischen dem nachfolgenden Messschritt (520) und dem nachfolgenden Vergleichungsschritt (530) der Routine (500) ausgeführt wird, des Werte der Spannung (V_{bat}), der mit einem dritten Korrekturfaktor (ΔC2) gemessen wird, der dritte Korrekturfaktor (ΔC2) abhängig von der Intensität (Iₚᵥ) des elektrischen Stroms ist, die an dem Solarmodul (25) gemessen wird, zum Zeitpunkt des nachfolgenden Messschritts (520) der Spannung (V_{bat}), die von der Batterie (24) während der Routine (500) geliefert wird.

5. Betriebssteuerverfahren einer motorisierten Antriebsvorrichtung (5) nach einem der Ansprüche 1 bis 4, **dadurch gekennzeichnet, dass** während des Erstellungsschritts (400) des Indikators (SOF) der Indikator (SOF) als gleich wie der kritische Anzeigezustand (SC) definiert wird (410; 430), wenn der Minimalwert (Vₘᵢₙ) der Spannung (V_{bat}) strikt kleiner als ein vorbestimmter minimaler Spannungsschwellenwert (V; V1) ist.

6. Betriebssteuerverfahren einer motorisierten Antriebsvorrichtung (5) nach einem der Ansprüche 1 bis 4, **dadurch gekennzeichnet,**
**dass** das Verfahren während der Messphase (P2) ferner Folgendes umfasst:
- einen Messschritt (370) einer Drehgeschwindigkeit (R) des Elektromotors (16) , und
- einen Aufzeichnungsschritt (390) eines maximalen Werts (Rₘₐₓ) der Drehgeschwindigkeit (R) des Elektromotors (16),
und **dass** während das Erstellungsschritt (400) des Indikators (SOF) dieser als gleich wie der Zustand der kritischen Anzeige (SC) definiert wird (450),
wenn der Minimalwert (Vₘᵢₙ) der aufgezeichneten Spannung (V_{bat}) strikt unter einem vorbestimmten minimalen Spannungsschwellenwert (V4) ist und der Maximalwert (Rₘₐₓ) der aufgezeichneten Drehgeschwindigkeit (R) gleichzeitig unter einem vorbestimmten Geschwindigkeitsschwellenwert (R1) bleibt.

7. Betriebssteuerverfahren einer motorisierten Antriebsvorrichtung (5) nach einem der Ansprüche 1 bis 6, **dadurch gekennzeichnet, dass** das Verfahren während der Analysephase (P3) ferner einen Anzeigeschritt (480, 580) des Indikators (SOF) auf einer Anzeigevorrichtung (38) umfasst.

8. Motorisierte Antriebsvorrichtung (5), die motorisierte Antriebsvorrichtung (5) mindestens umfassend:
- einen elektromechanischen Aktuator (11),
- eine elektronische Steuereinheit (15), und
- eine Versorgungsvorrichtung elektrischer Energie (26),
der elektromechanische Aktuator (11) umfassend mindestens einen Elektromotor (16), die Versorgungsvorrichtung elektrischer Energie (26) mindestens umfassend eine Batterie (24), wobei die elektronische Steuereinheit (15) und der Elektromotor (16) von der Batterie (24) mit elektrischer Energie versorgt werden, die Batterie (24) eine Spannung (V_{bat}) liefert,
**dadurch gekennzeichnet, dass** die elektronische Steuereinheit (15) der motorisierten Antriebsvorrichtung (5) konfiguriert ist, um das Verfahren nach einem der Ansprüche 1 bis 7 durchzuführen.

9. Abdeckvorrichtung (3), mindestens umfassend:
- einen Schirm (2), und
- eine motorisierte Antriebsvorrichtung (5),
wobei der Schirm (2) konfiguriert ist, um durch den elektromechanischen Aktuator (11) der motorisierten Antriebsvorrichtung (5) in Bewegung versetzt zu werden, **dadurch gekennzeichnet, dass** die motorisierte Antriebsvorrichtung (5) dem Anspruch 8 entspricht.

10. Abdeckvorrichtung (3) nach Anspruch 9, **dadurch gekennzeichnet,**
**dass** die Abdeckvorrichtung (3) ferner ein Wickelrohr (4) umfasst,
**dass** der Schirm (2) auf das Wickelrohr (4) aufwickelbar ist,
wobei das Wickelrohr (4) angeordnet ist, um durch den elektromechanischen Aktuator (11) in Drehung versetzt zu werden.

## Claims

1. A method for controlling the operation of a motorized driving device (5), the motorized driving device (5) comprising at least:
- an electromechanical actuator (11),
- an electronic control unit (15), and
- an electrical energy supply device (26),
the electromechanical actuator (11) comprising at least one electric motor (16),
the electrical energy supply device (26) comprising at least one battery (24), the electronic control unit (15) and the electric motor (16) being supplied with electrical energy from the battery (24), the battery (24) delivering a voltage (V_{bat}),
**characterised in that** the method comprises at least:
- a measurement phase (P2), implemented during a period of operation of the electric motor (16), in which the method comprises at least:
- a measurement step during operation (300, 330) of the voltage (V_{bat}) delivered by the battery (24), and
- a recording step during operation (310, 350) of a minimum value (Vₘᵢₙ) of the voltage (V_{bat}) delivered by the battery (24),
- and an analysis phase (P3), in which the method comprises at least:
- an establishment step (400) of an indicator (SOF) representative of the battery life of the battery (24), based on the minimum value (Vₘᵢₙ) of the voltage (V_{bat}) recorded during the measurement phase (P2), and
- after the period of operation of the electric motor (16), if the indicator (SOF) is equal to a critical indication state (SC), a routine (500) prohibiting the operation of the electric motor (16), the routine (500) being executed as long as the indicator (SOF) is equal to the critical indication state (SC),
and **in that** the method is implemented when the motorized driving device (5) moves a screen (2) of an occultation device (3), in a movement of the screen (2) requiring the greatest power delivered by the electromechanical actuator (11).

2. The method for controlling the operation of a motorized driving device (5) according to claim 1, **characterised in that** the movement of the screen (2) requiring the greatest power delivered by the electromechanical actuator (11) is an upward movement of the screen (2).

3. The method for controlling the operation of a motorized driving device (5) according to any one of claims 1 to 2, **characterised**
**in that** the method further comprises an initialisation phase (P1), implemented prior to the period of operation of the electric motor (16), during which the method further comprises:
- a preliminary measurement step (210) of the voltage (V_{bat}) delivered by the battery (24), and
- a preliminary recording step (220) of a value of the voltage (V_{bat}) measured as being a reference value (V_{ref}),
**in that** the method further comprises, during the routine (500), prohibiting the operation of the electric motor (16) and as long as the indicator (SOF) is equal to the critical indication state (SC):
- a subsequent measurement step (520) of the voltage (V_{bat}) delivered by the battery (24), and
- a subsequent comparison step (530) of a value of the measured voltage (V_{bat}) against the reference value (V_{ref}),
**in that**, if the value of the voltage (V_{bat}) measured, during the subsequent measurement step (520), is strictly less than a sum of the reference value (V_{ref}) of the voltage (V_{bat}) and a first predetermined correction factor (ΔV), the method implements again, during the routine (500), the subsequent measurement step (520) and the subsequent comparison step (530), after a delay step (540),
**in that**, if the value of the voltage (V_{bat}) measured, in the subsequent measurement step (520), is greater than or equal to the sum of the reference value (V_{ref}) of the voltage (V_{bat}) and the first predetermined correction factor (ΔV), the method further comprises, during the routine (500):
- a modification step (550) of the indicator (SOF), so that it is different from the critical indication state (SC), and
- an end step (560) of the routine (500),
and **in that** the first predetermined correction factor (ΔV) is a predetermined voltage value greater than or equal to zero.

4. The method for controlling the operation of a motorized driving device (5) according to claim 3, **characterised**
**in that** the electrical energy supply device (26) further comprises a photovoltaic panel (25), the photovoltaic panel (25) supplying electrical energy to the battery (24),
**in that** the method further comprises:
- during the initialisation phase (P1), a preliminary modification step (240) of the reference value (V_{ref}) of the voltage (V_{bat}) with a second correction factor (ΔC1), the second correction factor (ΔC1) being a function of the intensity (Iₚᵥ) of the electric current measured at the photovoltaic panel (25), at the time of the preliminary measurement step (210) of the voltage (V_{bat}) delivered by the battery (24) during the initialisation phase (P1), and
- during the routine (500), if the indicator (SOF) equals the critical indication state (SC), a subsequent modification step (570), executed between the subsequent measurement step (520) and the subsequent comparison step (530) of the routine (500), of the value of the measured voltage (V_{bat}) with a third correction factor (ΔC2), the third correction factor (ΔC2) being a function of the intensity (Iₚᵥ) of the electric current measured at the photovoltaic panel (25), at the time of the subsequent measurement step (520) of the voltage (V_{bat}) delivered by the battery (24) during the routine (500).

5. The method for controlling the operation of a motorized driving device (5) according to any one of claims 1 to 4, **characterised in that**, during the establishment step (400) of the indicator (SOF), the indicator (SOF) is defined (410; 430) as being equal to the critical indication state (SC) if the minimum value (Vₘᵢₙ) of the voltage (V_{bat}) is strictly less than a predetermined minimum voltage threshold value (V; V1).

6. The method for controlling the operation of a motorized driving device (5) according to any one of claims 1 to 4, **characterised**
**in that**, during the measurement phase (P2), the method further comprises:
- a measurement step (370) of a rotational speed (R) of the electric motor (16), and
- a recording step (390) of a maximum value (Rₘₐₓ) of the rotational speed (R) of the electric motor (16),
and **in that**, during the establishment step (400) of the indicator (SOF), the indicator (SOF) is defined (450) as being equal to the critical indication state (SC), if the minimum value (Vₘᵢₙ) of the voltage (V_{bat}) recorded is strictly less than a predetermined minimum voltage threshold value (V4) and if the maximum value (Rₘₐₓ) of the rotational speed (R) recorded is strictly less than a predetermined speed threshold value (R1).

7. The method for controlling the operation of a motorized driving device (5) according to any one of claims 1 to 6, **characterised in that** the method further comprises, during the analysis phase (P3), a display step (480, 580) of the indicator (SOF) on a display device (38).

8. A motorized driving device (5),
the motorized driving device (5) comprising at least:
- an electromechanical actuator (11),
- an electronic control unit (15), and
- an electrical energy supply device (26),
the electromechanical actuator (11) comprising at least one electric motor (16),
the electrical energy supply device (26) comprising at least one battery (24), the electronic control unit (15) and the electric motor (16) being supplied with electrical energy from the battery (24), the battery (24) delivering a voltage (V_{bat}),
**characterised in that** the electronic control unit (15) of the motorized driving device (5) is configured to implement the method according to any one of claims 1 to 7.

9. An occultation device (3) comprising at least:
- a screen (2), and
- a motorized driving device (5),
the screen (2) being configured to be moved by the electromechanical actuator (11) of the motorized driving device (5), **characterised in that** the motorized driving device (5) is according to claim 8.

10. The occultation device (3) according to claim 9, **characterised**
**in that** the occultation device (3) further comprises a winding tube (4),
**in that** the screen (2) can be rolled onto the winding tube (4),
and **in that** the winding tube (4) is arranged to be rotated by the electromechanical actuator (11).
